# EUROPEAN PATENT APPLICATION

(11) **EP 4 750 279 A1**
(43) Date of publication of application: **27.05.2026**
(21) Application number: 25202984.8
(22) Date of filing: 18.09.2025
(51) Int. Cl.: H10H 29/39

(54) **DISPLAY DEVICE**

(30) Priority: 22.11.2024 KR 20240168967
(71) Applicant: LG Display Co., Ltd., Seoul, 07336 (KR)
(72) Inventor: GWON, Hyangmyoung, 10845, Paju-si, Gyeonggi-do (KR); JUNG, JiHyun, 10845 Paju-si, Gyeonggi-do (KR); RHE, Ruda, 10845 Paju-si, Gyeonggi-do (KR)
(74) Representative: Viering, Jentschura & Partner mbB Patent- und Rechtsanwälte

(57) **Abstract**

A display device (100) according to embodiments of the present disclosure may include a substrate (210), a plurality of light emitting devices (ED) disposed on the substrate (210) and positioned in a display area (DA), a plurality of column lines (CL) electrically connected to a first electrode (Ecl) of each of the plurality of light emitting devices (ED), a plurality of row lines (RL) electrically connected to a second electrode (Erl) of each of the plurality of light emitting devices (ED), a plurality of drivers (DRV) configured to drive the plurality of column lines (CL) and the plurality of row lines (RL), and a plurality of row connection lines (RCL) electrically connecting the plurality of row lines (RL) and the plurality of drivers (DRV). At least one of the plurality of row connection lines (RCL) may include a multi-wiring section (RCL_D) including two or more conductive layers vertically overlapping with each other with an insulating layer interposed therebetween.

## Description

### TECHNICAL FIELD

Embodiments of the present disclosure relate to a display device, and particularly to, for example, without limitation, a display device capable of having a touch sensor built into a display panel.

### DESCRIPTION OF RELATED ART

A display device is applied to various electronic devices such as televisions, mobile phones, laptops, and tablets. A display device may include an organic light emitting display (OLED) including a self-luminous emit lighting device, and a liquid crystal display (LCD) with a separate light source.

Recently, a display device with light emitting diodes (LED) such as micro-LED, mLED, or µLED is attracting attention as a next-generation display device. Since light emitting diodes are made of inorganic materials rather than organic materials, a display device with the light emitting diode has a characteristics of a faster lighting speed, superior light emitting efficiency, and can display high-luminance images compared to a liquid crystal display or an organic light emitting display.

The description provided in the background section should not be assumed to be prior art merely because it is mentioned in or associated with the background section. The background section may include information that describes one or more aspects of the subject technology.

### SUMMARY

An aspect of the present disclosure may be to provide a display device having a touch sensor built into a display panel including a light emitting device.

Another aspect of the present disclosure may be to provide a display device having a structure in which a plurality of rows lines, which are a type of wiring or electrode for driving a plurality of light emitting devices, are used as touch sensors or touch electrodes.

Still another aspect of the present disclosure may be to provide a display device capable of reducing resistance in the connection structure between the row line as a touch sensor and the driver.

Yet another aspect of the present disclosure may be to provide a display device capable of embeding a driver for display driving and touch driving into the display panel, thereby reducing the number of driving components (e.g. drivers) connected to the outside of a display panel, reducing the number of assembly processes in the manufacturing process and providing a structure capable of process optimization.

Aspects of the embodiments of the present disclosure are not limited to the aspects described in this disclosure, and other aspects not mentioned will be clearly understood by those skilled in the art from the description below. According to an aspect of the present disclosure, a display device according to claim 1 is provided. Exemplary embodiments of the display device are described in the dependent claims.

To achieve the aforementioned and other aspects of the inventive concepts, as embodied and broadly described herein, a display device according to example embodiments of the present disclosure may include a substrate, a plurality of light emitting devices disposed on the substrate and positioned in a display area, a plurality of column lines electrically connected to a first electrode of each of the plurality of light emitting devices, a plurality of row lines electrically connected to a second electrode of each of the plurality of light emitting devices, a plurality of drivers configured to drive the plurality of column lines and the plurality of row lines, and a plurality of row connection lines electrically connecting the plurality of row lines and the plurality of drivers, wherein at least one of the plurality of row connection lines includes a multi-wiring section including two or more conductive layers vertically overlapping with each other with an insulating layer interposed therebetween.

In another aspect, a display device according to embodiments of the present disclosure may include a substrate, a plurality of light emitting devices disposed on the substrate and positioned in a display area, a first line overlapping with the plurality of light emitting devices, and a first connection line electrically connected to the first line, and including a multi-wiring section including two or more conductive layers vertically overlapping with each othe with an insulating layer interposed therebetween.

In yet another aspect, a display device according to embodiments of the present disclosure may include: a substrate; a driver disposed on the substrate; a plurality of light emitting devices disposed over the driver; and a first line overlapping with the plurality of light emitting devices and electrically connected with the plurality of light emitting devices, wherein during a touch period of the display device, the first line is supplied with a touch driving signal from the driver.

According to embodiments of the present disclosure, it is possible to provide a display device having a touch sensor built into a display panel including a light emitting device.

According to embodiments of the present disclosure, it is possible to provide a display device having a structure in which a plurality of rows lines, which are a type of wiring or electrode for driving a plurality of light emitting devices, are used as touch sensors.

According to embodiments of the present disclosure, it is possible to provide a display device capable of reducing resistance in the connection structure between the row line as a touch sensor and the driver.

According to embodiments of the present disclosure, it is possible to provide a display device capable of embeding a driver for display driving and touch driving into the display panel, thereby reducing the number of driving components (e.g. drivers) connected to the outside of a display panel, reducing the number of assembly processes in the manufacturing process and providing a structure capable of process optimization.

The effects of the embodiments of the present disclosure are not limited to the effects mentioned above, and other effects not mentioned will be clearly understood by those skilled in the art from the description of the claims.

It is to be understood that both the foregoing general description and the following detailed description are exemplary and explanatory and are intended to provide further explanation of the inventive concepts as claimed.

### BRIEF DESCRIPTION OF THE DRAWINGS

The accompanying drawings, that may be included to provide a further understanding of the disclosure and may be incorporated in and constitute a part of the disclosure, illustrate embodiments of the disclosure and together with the description serve to explain various principles of the disclosure.
FIG. 1 illustrates a display device according to example embodiments of the present disclosure.
FIG. 2 is a plan view of a display device according to example embodiments of the present disclosure.
FIG. 3 is a plan view of a display panel according to example embodiments of the present disclosure.
FIG. 4 is a plan view of a unit driving area of a display panel according to example embodiments of the present disclosure.
FIG. 5 illustrates a sub-pixel of a display panel according to example embodiments of the present disclosure.
FIG. 6 is a plan view of a display panel according to example embodiments of the present disclosure.
FIG. 7 and FIG. 8 are plan views of a portion of a display panel according to example embodiments of the present disclosure.
FIG. 9 is a cross-sectional view of a display panel according to example embodiments of the present disclosure.
FIG. 10 is a detailed cross-sectional view of a display panel according to example embodiments of the present disclosure, taken along the A-B cutting line of FIG. 6.
FIG. 11 is an enlarged cross-sectional view of a first sub-pixel of a display panel according to example embodiments of the present disclosure.
FIG. 12 briefly illustrates a touch sensing structure of a display device according to example embodiments of the present disclosure.
FIG. 13 and 14 illustrate a touch sensor structure of a display panel according to example embodiments of the present disclosure.
FIG. 15 and 16 are driving timing diagrams of a display device according to example embodiments of the present disclosure.
FIGS. 17 and 18 illustrate a connection structure between a row line and a driver in a display panel according to example embodiments of the present disclosure.
Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to embodiments of the present disclosure, examples of which may be illustrated in the accompanying drawings. In the following description, when a detailed description of well-known functions or configurations related to this document is determined to unnecessarily cloud a gist of the inventive concept, the detailed description thereof will be omitted. The progression of processing steps and/or operations described is an example; however, the sequence of steps and/or operations is not limited to that set forth herein and may be changed as is known in the art, with the exception of steps and/or operations necessarily occurring in a particular order. Like reference numerals designate like elements throughout. Names of the respective elements used in the following explanations may be selected only for convenience of writing the specification and may be thus different from those used in actual products.

The advantages and features of the present disclosure and the method for achieving them will become clear with reference to the example embodiments described in detail below together with the accompanying drawings. However, the present disclosure is not limited to the example embodiments disclosed below, but may be implemented in various different forms, and these example embodiments are provided only to make the disclosure of the present disclosure complete and to fully inform a person having ordinary skill in the art to which the present disclosure belongs of the scope of the present disclosure. Any implementation described herein as an "example" is not necessarily to be construed as preferred or advantageous over other implementations.

The shapes, sizes, ratios, angles, numbers, etc. disclosed in the drawings for explaining the embodiments of this disclosure are exemplary, and therefore this disclosure is not limited to the matters illustrated. In assigning reference numerals to components of each drawing, the same components may be assigned the same numerals even when they are shown on different drawings. When determined to make the subject matter of the disclosure unclear, the detailed of the known art or functions may be skipped. As used herein, when a component "includes," "has," or "is composed of" another component, other components may be added unless a more limiting term such as "only" is used. An element described in the singular form is intended to include a plurality of elements, and vice versa, unless the context clearly indicates otherwise.

In interpreting a component, even if there is no separate explicit description of the error range, it is interpreted as including the error range.

Where positional relationships are described, for example, where the positional relationship between two parts is described using "on," "over," "under," "above," "below," "beneath," "near," "close to," or "adjacent to," "beside," "next to," or the like, one or more other parts may be disposed between the two parts unless a more limiting term, such as "immediate(ly)," "direct(ly)," or "close(ly)" is used. For example, when a structure is described as being positioned "on," "over," "under," "above," "below," "beneath," "near," "close to," or "adjacentto," "beside," or "next to" another structure, this description should be construed as including a case in which the structures contact each other as well as a case in which a third structure is disposed or interposed therebetween. Furthermore, the terms "left," "right," "top," "bottom, "downward," "upward," "upper," "lower," and the like refer to an arbitrary frame of reference.

In describing a temporal relationship, when the temporal order is described as, for example, "after," "following," "subsequent," "next," and "before," a case that is not continuous may be included unless a more limiting term, such as "just," "immediate(ly)," or "direct(ly)" is used.

Although the terms first, second, etc. are used to describe various elements, the essence, sequence, order, or number of these components are not limited by these terms. These terms are only used to distinguish one component from another. For example, a first component could be termed a second component, and, similarly, a second component could be termed a first component, without departing from the scope of the present disclosure.

In describing the components of this disclosure, terms such as first, second, A, B, (a), or (b) may be used. These terms are only intended to distinguish the components from other components, and the nature, order, sequence, or number of the components are not limited by the terms.

If a component is described as being "connected," "coupled," "linked," or "attached," to another component, it should be understood that the component may be directly connected, coupled, linked, or attached to the other component, but that other components may be interposed between each component that may be indirectly connected, coupled, linked, or attached without any specific explicit description.

When a component or layer is described as being "contacted," or "overlapping," to another component or layer, it should be understood that the component or layer may directly contact or overlap the other component or layer, but that other components may be interposed between each component that may be indirectly contacted or overlapped without any specific explicit description.

"At least one" should be understood to include any combination of one or more of the associated components. For example, "at least one of the first, second, and third components" can be interpreted to include not only the first, second, or third components, but also any combination of two or more of the first, second, and third components.

"First direction," "Second direction," "Third direction," "row direction", "column direction", "X-axis direction," "Y-axis direction," and "Z-axis direction" should not be interpreted as merely geometric relationships in which the relationship between them is perpendicular to each other, but can mean a wider directionality within the range in which the configuration of the present disclosure can function functionally.

Each feature of the various embodiments of the present disclosure can be partially or wholly combined or combined with each other, and various technical connections and operations are possible, and each embodiment can be implemented independently of each other or can be implemented together in a related relationship.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

Hereinafter, various example embodiments of the disclosure are described in detail with reference to the accompanying drawings. Further, all the components of each display device according to all embodiments of the present disclosure are operatively coupled and configured.

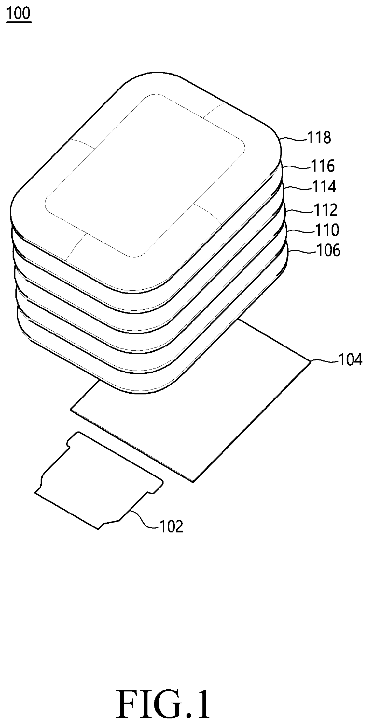

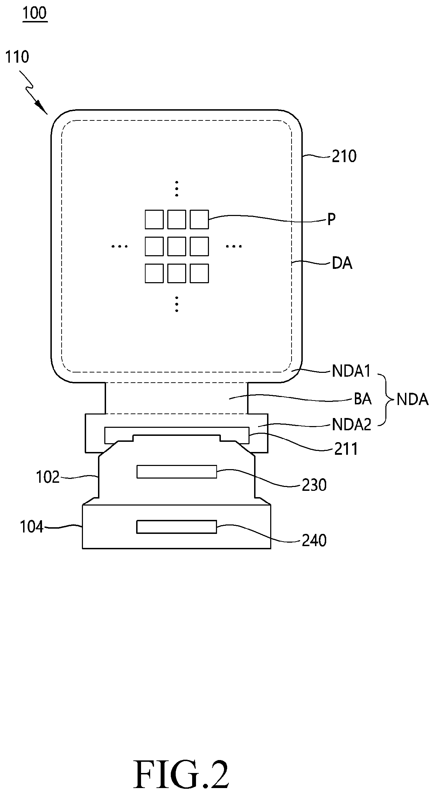

FIG. 1 illustrates a display device 100 according to embodiments of the present disclosure, and FIG. 2 is a plan view of a display device 100 according to embodiments of the present disclosure.

Referring to FIG. 1, a display device 100 according to the embodiments of the present disclosure may include one or more of a display panel 110, a cover member 118 disposed on the display panel 110, a flexible printed circuit 102 connected to the display panel 110, and a printed circuit board 104 connected to the flexible printed circuit 102. However, the present disclosure is not limited thereto, and more or less components may be included in the display device of the present disclosure. For example, various other function layers such as a diffusion layer, a reflective layer may also be disposed on the display panel 110.

The display device 100 according to the embodiments of the present disclosure may further include a support substrate 106 disposed under the display panel 110 and supporting the lower portion of the display panel 110, a polarizing layer 114 disposed on the display panel 110, a first adhesive layer 112 disposed between the display panel 110 and the polarizing layer 114, and a second adhesive layer 116 disposed between the polarizing layer 114 and the cover member 118.

The display panel 110 may include a substrate 210. The substrate 210 may be a member on which various components such as a plurality of conductive layers and a plurality of insulating material layers are formed. The substrate 210 may be made of an insulating material. For example, the substrate 210 may be made of glass or resin. In addition, the substrate 210 may be made of a flexible material. For example, the substrate 210 may be made of a flexible plastic material such as any one of polyethylene terephthalate(PET), polycarbonate(PC), acrylonitrile-butadiene-styrene copolymer(ABS), polymethyl methacrylate(PMMA), polyethylene naphthalate(PEN), polyether sulfone(PES), cyclic olefin copolymer(COC), triacetylcellulose(TAC), polyvinyl alcohol(PVA), polyimide(PI), and polystyrene(PS). However, the example embodiments of the present disclosure are not limited thereto.

The display panel 110 may display information, images, and/or images provided to a user. For example, the display panel 110 may include a display area DA and a non-display area NDA adjacent to the display area DA. For example, the substrate 210 may include a display area DA and a non-display area NDA. The display area DA and the non-display area NDA are not limited to the substrate 210, but can be described throughout the entire display device 100.

The display area DA may be an area where an image is displayed. The display area DA may include a plurality of pixels P. Each of the plurality of pixels P may be composed of a plurality of sub-pixels. At least one light emitting device may be arranged in each of the plurality of sub-pixels. The light emitting device may be configured differently depending on the type of the display device 100. For example, if the display device 100 is an inorganic light emitting display device, the light emitting device may be an inorganic-based light emitting device, such as a light emitting diode (LED), a micro LED, or a mini LED, but the example embodiments of the present disclosure are not limited thereto. Hereinafter, the description will be made by assuming that the light emitting diode of the display device 100 according to the example embodiment of the present disclosure is a micro LED, but the example embodiments of the present disclosure are not limited thereto.

The non-display area NDA may be an area where an image is not displayed. In the non-display area NDA, various wirings, and circuits for driving a plurality of pixels P of the display area DA may be arranged. For example, various driving circuits and various wirings may be arranged in the non-display area NDA, and a pad section 211 to which an integrated circuit and a printed circuit are connected may be arranged.

For example, the driving circuit may include a data driving circuit and/or a gate driving circuit, but the embodiments of the present disclosure are not limited thereto. Wires or lines supplied with a control signal for controlling the driving circuit may be arranged on the substrate 210. For example, the control signal may include various timing signals including a clock signal, an input data enable signal, and synchronization signals, but the embodiments of the present disclosure are not limited thereto. The control signal may be supplied to the substrate 210 from the outside of the substrate 210 through the pad section 211. For example, circuit components such as a flexible printed circuit 102 and a printed circuit board 104 may be connected to the pad section 211.

The non-display area NDA may include a first non-display area NDA1, a bending area BA, and a second non-display area NDA2. For example, the first non-display area NDA1 may be an area surrounding at least a portion of the display area DA. The bending area BA may be an area extending from at least one of a plurality of sides of the first non-display area NDA1 and may be a bendable area. The second non-display area NDA2 may be an area extending from the bending area BA and may include a pad section 211. For example, the bending area BA may be in a bent state, and the remaining area of the substrate 210 excluding the bending area BA may be in a flat state. In this case, as the bending area BA is bent, the second non-display area NDA2 may be located on the back surface of the display area DA.

The display area DA of the substrate 210 or the display device 100 may be configured in various shapes according to the design of the display device 100. For example, the display area DA may be configured in a rectangular shape with four corners formed in a round shape, a rectangular shape with four corners formed in a right angle shape, or a circular shape.

A width of the second non-display area NDA2 where the pad section 211 is arranged may be wider than a width of the bending area BA. In addition, a width of the display area DA may be wider than the width of the bending area BA. In the drawing, the width of the bending area BA is depicted as being narrower than the width of other areas of the substrate 210, but the shape of the substrate 210 including the bending area BA is exemplary, and the embodiments of the present disclosure are not limited thereto.

The flexible printed circuit (also referred to as flexible circuit board or flexible film) 102 and a printed circuit board 104 may be disposed at a lower portion of the display panel 110. For example, the flexible printed circuit 102 and the printed circuit board 104 may be arranged at one edge of the display panel 110. One side of the flexible printed circuit 102 may be connected to the display panel 110, and the other side may be connected to the printed circuit board 104. The flexible printed circuit 102 may be a flexible film.

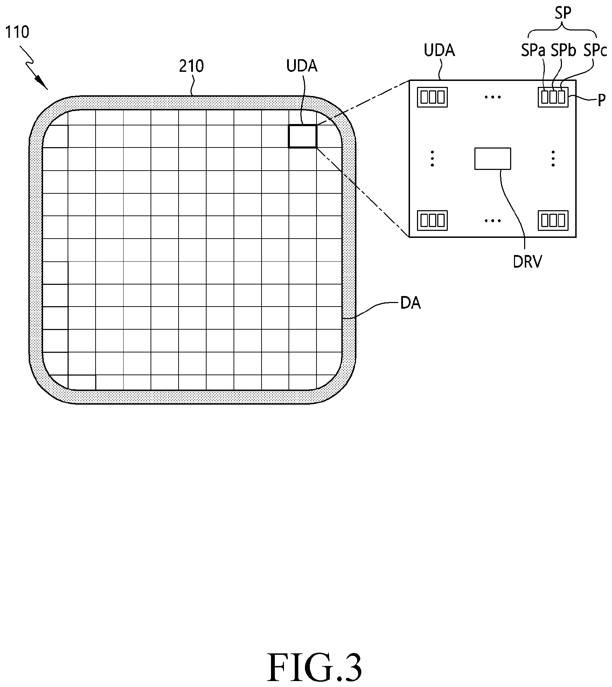

The pad section 211 disposed in the second non-display area NDA2 includes a plurality of pads, and a driving component including one or more flexible printed circuits 102 and a printed circuit board 104 can be attached or bonded. The plurality of pads included in the pad section 211 are electrically connected to one or more flexible printed circuits 102, and may transmit various signals (or power) from the printed circuit board 104 and one or more flexible printed circuits 102 to a driving circuit (for example, a driver DRV of FIG. 3) arranged in the display area DA.

The flexible printed circuit 102 may be a film in which various components are arranged on a flexible base film. For example, a first circuit component 230, such as a gate drive integrated circuit and/or a data drive integrated circuit, may be arranged on one or more flexible printed circuits 102. The first circuit component 230 may be a component that processes data and a driving signal for displaying an image. The flexible printed circuit 102 may be attached or bonded to a plurality of pads through a conductive adhesive layer.

The printed circuit board 104 may be a component that is electrically connected to the flexible printed circuit 102 and supplies a signal to the first circuit component 230. The printed circuit board 104 may be arranged on one side of the flexible printed circuit 102 and may be electrically connected to the flexible printed circuit 102. Various components for supplying various signals to the first circuit component 230 may be arranged on the printed circuit board 104. For example, various second circuit components 240, such as a timing controller, a power supply, a memory, or a processor, may be arranged on the printed circuit board 104. For example, the second circuit components 240 arranged on the printed circuit board 104 may include a timing controller and/or a power management integrated circuit (PMIC). The first circuit components 230 and the second circuit components 240 may be disposed by a chip on glass (COG), a chip on film (COF), or a tape carrier package (TCP) technique depending on a mounting method, but the example embodiments of the present disclosure are not limited thereto.

The printed circuit board 104 may include at least one hole, but the embodiments of the present disclosure are not limited thereto. An internal component (e.g., light sensor or temperature sensor) detecting ambient light or temperature may be arranged in an area corresponding to at least one hole (e.g., transmission hole). For example, the internal component may include an ambient light sensor (ALS) or a temperature sensor, but the example embodiments of the present disclosure are not limited thereto. For example, the hole may be a transmission region or hole, but the example embodiments of the present disclosure are not limited thereto.

A polarizing layer 114 may be arranged on a display panel 110 and may prevent or reduce light generated from an external light source from entering the display panel 110 and affecting a light emitting device.

A cover member 118 may be arranged on a polarizing layer 114 and may be a member for protecting the display panel 110.

A second adhesive layer 116 may be disposed between the polarizing layer 114 and the cover member 118. The second adhesive layer 116 may attach the cover member 118 to the display panel 110 or the polarizing layer 114. A first adhesive layer 112 may be disposed between the display panel 110 and the polarizing layer 114. The first adhesive layer 112 may attach the polarizing layer 114 to the display panel 110. The first adhesive layer 112 may be omitted. Each of the first adhesive layer 112 and the second adhesive layer 116 may include an optically clear adhesive (OCA), an optically clear resin (OCR), or a pressure sensitive adhesive (PSA).

The support substrate 106 is disposed between the display panel 110 and the printed circuit board 104 to reinforce the rigidity of the display panel 110. The support substrate 106 may be a back plate. The support substrate 106 may be omitted when necessary.

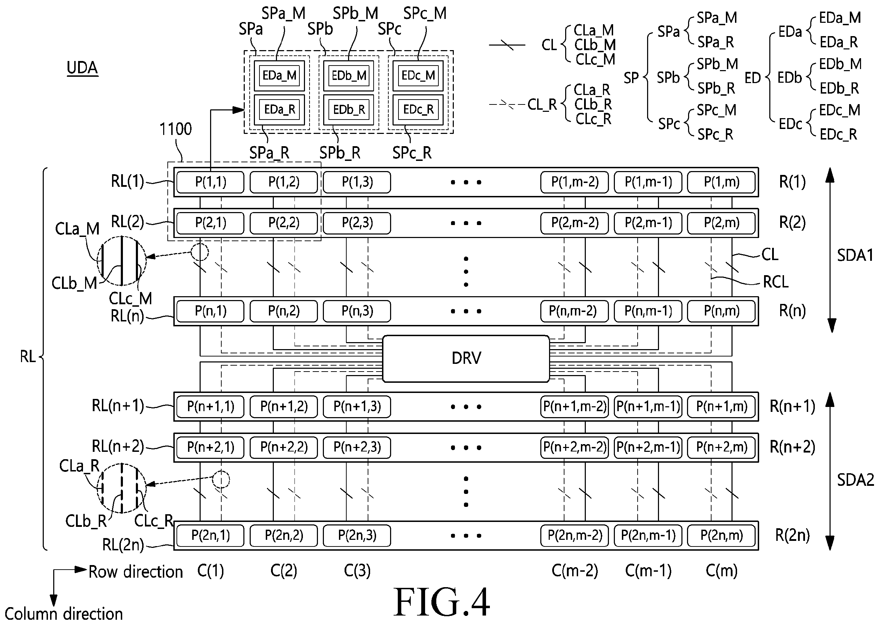

FIG. 3 is a plan view of a display panel 110 according to embodiments of the present disclosure, and FIG. 4 is a plan view of a unit driving area UDA of a display panel 110 according to embodiments of the present disclosure.

Referring to FIG. 3, the display area DA of the display panel 110 according to the embodiments of the present disclosure may include a plurality of unit driving areas (or unit display area) UDA.

The display panel 110 may include a plurality of drivers DRV. The plurality of drivers DRV may be arranged in each of the plurality of unit driving areas UDA. For example, one driver DRV may be disposed in one unit driving area UDA, but the present disclosure is not limited thereto. Each of the plurality of unit driving areas UDA may be a driving area driven by one driver DRV. For example, the driver DRV may be a driving chip manufactured using a MOSFET (Metal-oxide-silicon field effect transistor) manufacturing process on a semiconductor substrate. The display panel 110 may include a substrate 210 including a display area DA, and a plurality of pixels P arranged in a matrix form in the display area DA.

A plurality of pixels P may be arranged in each of the plurality of unit driving areas UDA. Each of the plurality of pixels P may include a plurality of sub-pixels SP. Each of the plurality of sub-pixels SP may include at least one light emitting device.

For example, the plurality of sub-pixels SP may include a first sub-pixel SPa, a second sub-pixel SPb, and a third sub-pixel SPc. The first sub-pixel SPa may include a first light emitting device that emits a first color light, the second sub-pixel SPb may include a second light emitting device that emits a second color light, and the third sub-pixel SPc may include a third light emitting device that emits a third color light. For example, the first color light, the second color light, and the third color light may be red light, green light, and blue light, respectively.

The display panel 110 may include a plurality of row lines RL and a plurality of column lines CL. Each of the plurality of row lines RL may be arranged to extend in a row direction. The plurality of row lines RL may be electrically connected to a first electrode of each of a plurality of light emitting devices ED. Each of the plurality of column lines CL may be arranged to extend in a column direction. The plurality of column lines CL may be electrically connected to a second electrode of each of the plurality of light emitting device ED.

For example, the first electrode of each of the plurality of light emitting device ED may be an anode electrode, and the second electrode of each of the plurality of light emitting device ED may be a cathode electrode. For another example, the first electrode of each of the plurality of light emitting device ED may be a cathode electrode, and the second electrode of each of the plurality of light emitting device ED may be an anode electrode.

Each of the plurality of row lines RL may be electrically connected to the second electrode of each of the plurality of light emitting device ED. For example, the second electrodes of each of the plurality of light emitting device ED may be commonly connected to one row line RL.

Each of the plurality of column lines CL may be electrically connected to the first electrode of each of the plurality of light emitting device ED. For example, the first electrode of each of the plurality of light emitting device ED may be commonly connected to one column line CL.

For example, the line width of each of the plurality of row lines RL may be greater than the line width of each of the plurality of column lines CL.

Referring to FIG. 4, the plurality of drivers DRV may drive the plurality of light emitting device ED, the plurality of column lines CL, and the plurality of row lines RL.

Each of the plurality of drivers DRV can drive a plurality of row lines RL and a plurality of column lines CL arranged in a corresponding unit driving area UDA among the plurality of unit driving areas UDA, thereby emitting light from a plurality of light emitting device ED arranged in the corresponding unit driving area UDA.

The plurality of drivers DRV may be built into the display panel 110. The plurality of drivers DRV may be disposed in the display area DA, and may be arranged on the substrate 210. The plurality of drivers DRV may be disposed to correspond to a plurality of unit driving areas UDA. For example, one driver DRV may be disposed in one unit driving area UDA.

The plurality of drivers DRV are disposed in the display area DA, and may be positioned closer to the substrate 210 than the plurality of light emitting device ED. In this case, the plurality of drivers DRV may be disposed between the substrate 210 and the plurality of light emitting device ED, and thus may be referred to as a driving circuit or a driving circuit layer.

For example, the plurality of row lines RL may be driven sequentially. For another example, the plurality of row lines RL may be driven simultaneously. For another example, two or more row lines RL among the plurality of row lines RL may be driven simultaneously.

For example, during a specific display driving period, among the plurality of row lines RL arranged in the unit driving area UDA, at least one row line RL may be driven, and the remaining row lines RL may not be driven.

A voltage applied to the row line RL may be referred to as a low-potential voltage, and the low-potential voltage may also be referred to as a row line voltage or a cathode voltage. The low-potential voltage may have various voltage values depending on the driving type or driving state. For example, the low-potential voltage may include a first low-potential voltage, a second low-potential voltage, and a third low-potential voltage.

Driving the row line RL may mean that the first low-potential voltage is supplied to the row line RL. Not driving the row line RL may mean that the second low-potential voltage higher than the first low-potential voltage is supplied to the row line RL, or the row line RL is floated. Accordingly, the light emitting device ED overlapping with the driven row line RL may emit light, and the light emitting device ED overlapping with the non-driven row line RL may not emit light.

The structure of one unit driving area UDA will be described in more detail with reference to FIG. 4.

As an example, one unit driving area UDA may be divided into a first sub-driving area SDA1 and a second sub-driving area SDA2. As another example, one unit driving area UDA may be divided into three or more sub-driving areas. As another example, one unit driving area UDA may not be divided into two or more sub-driving areas.

One unit driving area UDA may include one driver DRV and (2n×m) pixels P(1, 1), ... , P(1, m), P(2, 1), ... , P(2, m), ... , P(2n, 1), ... , P(2n, m) driven by one driver DRV.

In the embodiments of the present disclosure, n may be a sequence number of a row, or the number of rows in each of the first sub-driving area SDA1 and the second sub-driving area SDA2, or the number of row lines RL in each of the first sub-driving area SDA1 and the second sub-driving area SDA2, or the number of pixel rows in each of the first sub-driving area SDA1 and the second sub-driving area SDA2. m may be a sequence number of a column, or the number of columns in each of the first sub-driving area SDA1 and the second sub-driving area SDA2, or the number of column lines CL in each of the first sub-driving area SDA1 and the second sub-driving area SDA2, or the number of pixel columns in each of the first sub-driving area SDA1 and the second sub-driving area SDA2. In the embodiments of the present disclosure, n may be a natural number greater than or equal to 1, and m may be a natural number greater than or equal to 1.

(2n×m) pixels P(1, 1), ... , P(1, m), P(2, 1), ... , P(2, m), ... , P(2n, 1), ... , P(2n, m) may be arranged in 2n rows R(1), ... , R(2n) and m columns C(1), ... , C(m).

Among (2n×m) pixels P(1, 1), ... , P(1, m), P(2, 1), ... , P(2, m), ... , P(2n, 1), ... , P(2n, m), one set of (n×m) pixels P(1, 1), ... , P(1, m), P(2, 1), ... , P(2, m), ... , P(n, 1), ... , P(n, m) arranged in the first to n-th rows R(1), ... , R(n) may be arranged in the first sub-driving area SDA1.

Among (2n×m) pixels P(1, 1), ... , P(1, m), P(2, 1), ... , P(2, m), ... , P(2n, 1), ... , P(2n, m), another set of (n×m) pixels P(n+1, 1), ... , P(n+1, m), P(n+2, 1), ... , P(n+2, m), ... , P(2n, 1), ... , P(2n, m) arranged in the (n+1)-th to the 2n-th row R(n+1), ... , R(2n) may be arranged in the second sub-driving area SDA2.

One unit driving area UDA may include 2n row lines RL(1), ..., RL(2n) to drive (2n×m) pixels P(1, 1), ..., P(1, m), P(2, 1), ..., P(2, m), ..., P(2n, 1), ..., P(2n, m).

Among the 2n row lines RL(1), ..., RL(2n), the first to n-th row lines RL(1), ..., RL(n) may be arranged in the first sub-driving area SDA1. Among the 2n row lines RL(1), ... , RL(2n), the (n+1)-th to the 2n-th row lines RL(n+1), ... , RL(2n) may be arranged in the second sub-driving area SDA2.

Each of the 2n row lines RL(1), ... , RL(2n) may overlap with m pixels. For example, the first row line RL(1) may overlap with m pixels P(1, 1), ... P(1, m) arranged in the first row R(1). The n-th row line RL(n) may overlap with m pixels P(n, 1), ... P(n, m) arranged in the n-th row (R(n)). The (n+1)-th row line RL(n+1) may overlap with the m pixels P(n+1, 1), ... P(n+1, m) arranged in the (n+1)-th row R(n+1). The 2n-th row line RL(2n) may overlap with the m pixels P(2n, 1), ... P(2n, m) arranged in the 2nth row R(2n).

For example, each of the m pixels P(n, 1), ... P(n, m) may include k sub-pixels SPa, SPb and SPc.

A first sub-pixel SPa may include a first light emitting device EDa that emits a first color light. The first sub-pixel SPa may include at least one of a first main sub-pixel SPa_M and a first redundancy sub-pixel SPa_R. The first light emitting device EDa included in the first sub-pixel SPa may include at least one of a first main light emitting device EDa_M included in the first main sub-pixel SPa_M and a first redundancy light emitting device EDa_R included in the first redundancy sub-pixel SPa_R.

A second sub-pixel SPb may include a second light emitting device EDb that emits a second color light. The second sub-pixel SPb may include at least one of the second main sub-pixel SPb_M and the second redundancy sub-pixel SPb_R. The second light emitting device EDb included in the second sub-pixel SPb may include at least one of the second main light emitting device EDb_M included in the second main sub-pixel SPb_M and the second redundancy light emitting device EDb_R included in the second redundancy sub-pixel SPb_R.

A third sub-pixel SPc may include a third light emitting device EDc that emits third color light. The third sub-pixel SPc may include at least one of the third main sub-pixel SPc_M and the second redundancy sub-pixel SPc_R. The third light emitting device EDc included in the third sub-pixel SPc may include at least one of the third main light emitting device EDc_M included in the third main sub-pixel SPc_M and the third redundancy light emitting device EDc_R included in the third redundancy sub-pixel SPc_R. Each row line of a row may be connected to k sub-pixels SPa, SPb and SPc included in each of m pixels arranged in the corresponding row. More specifically, each row line may be connected to second electrodes of k light emitting devices EDa, EDb and EDc included in each of m pixels arranged in the corresponding row.

For example, the first row line RL(1) may be connected to k sub-pixels SPa, SPb and SPc included in each of m pixels P(1, 1), ... P(1, m) arranged in the first row R(1). More specifically, the first row line RL(1) may be connected to the second electrodes of k light emitting devices EDa, EDb and EDc included in each of m pixels P(1, 1), ... P(1, m) arranged in the first row R(1).

Referring to FIG. 4, one unit driving area UDA may include (m×k×2) (main) column lines CL (CLa_M, CLb_M and CLc_M) to drive (2n×m) pixels P(1, 1), ... , P(1, m), P(2, 1), ... , P(2, m), ... , P(2n, 1), ... , P(2n, m), and in some cases, may further include (m×k×2) redundancy column lines CL_R (CLa_R, CLb_R and CLc_R). Here, k is the number of sub-pixels SP included in one pixel P. In the example of FIG. 4, k is 3, but the present disclosure is not limited thereto. For example, one pixel P may include three sub-pixels SPa, SPb and SPc.

Each of the (m×k×2) (main) column lines CL (CLa_M, CLb_M and CLc_M) may be commonly connected to first electrodes of a plurality of main light emitting devices arranged in the same column. Each of the (m×k×2) redundancy column lines CL_R (CLa_R, CLb_R and CLc_R) may be commonly connected to first electrodes of a plurality of redundancy light emitting devices arranged in the same column.

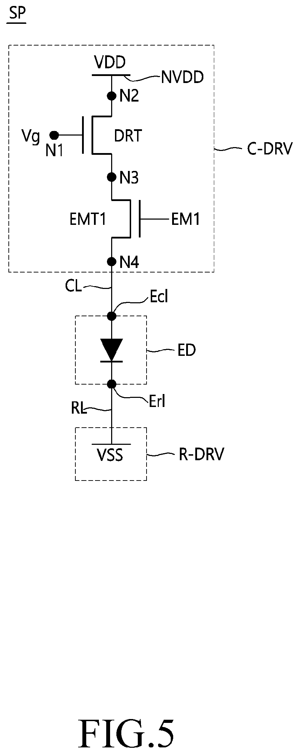

FIG. 5 illustrates a sub-pixel SP of a display panel 110 according to embodiments of the present disclosure.

Referring to FIG. 5, the sub-pixel SP according to embodiments of the present disclosure may include a light emitting device ED including a first electrode Ecl and a second electrode Erl, a column driver C-DRV for driving a column line CL electrically connected to the first electrode Ecl of the light emitting device ED, and a row driver R-DRV for driving a row line RL electrically connected to the second electrode Erl of the light emitting device ED. In another example, the column driver C-DRV and the row driver R-DRV may be included or integrated as a part of the driver DRV.

The light emitting device ED may include a first electrode Ecl and a second electrode Erl. The first electrode Ecl may be electrically connected to a column line CL, and the second electrode Erl may be electrically connected to a row line RL. For example, the first electrode Ecl may be an anode electrode, and the second electrode Erl may be a cathode electrode. For another example, the first electrode Ecl may be a cathode electrode, and the second electrode Erl may be an anode electrode.

The column driver C-DRV included in a unit driving area UDA may be connected to a plurality of column lines CL included in the unit driving area UDA, and may drive a plurality of column lines CL included in the unit driving area UDA. Each of the plurality of column lines CL may be commonly connected to the first electrode Ecl of each of the plurality of light emitting devices ED included in the plurality of sub-pixels SP arranged in the corresponding column.

The row driver R-DRV included in a unit driving area UDA may be connected to a plurality of row lines RL included in the unit driving area UDA and may drive a plurality of row lines RL included in the unit driving area UDA. Each of the plurality of row lines RL may be commonly connected to a second electrode Erl of each of a plurality of light emitting devices ED included in a plurality of sub-pixels SP arranged in the corresponding row.

The column driver C-DRV may include main nodes including a first node N1, a second node N2, a third node N3, and a fourth node N4. The column driver C-DRV may include a driving transistor DRT and a first emission control transistor EMT1, but the present disclosure is not limited thereto. For example, one or more other transistors and one or more capacitors may be included in the column driver C-DRV or the driver DRV. For example, 2T1C, 3T1C, 4T1C, 5T1C, 3T2C, 4T2C, 5T2C, 6T2C, 7T1C, 7T2C, 8T2C structures, etc. are also possible for the column driver C-DRV or the driver DRV.

The first node N1 may be a node to which a voltage Vg for controlling the on-off of the driving transistor DRT is applied. The second node N2 may be a node electrically connected to a high-potential voltage node NVDD to which a high-potential voltage VDD is applied. The third node N3 may be a node to which the driving transistor DRT and the first emission control transistor EMT1 are connected. The fourth node N4 may be a node to which the first emission control transistor EMT1 and the light emitting device ED are electrically connected, and may be a node to which the column line CL is electrically connected. Here, a source electrode or a drain electrode of the first emission control transistor EMT1 and the first electrode Ecl of the light emitting device ED may be commonly connected to the column line CL.

The driving transistor DRT supplies a driving current to make the light emitting device ED emit light, is connected between the second node N2 and the third node N3, and may control the connection between the second node N2 and the third node N3 according to the voltage of the first node N1.

The gate electrode of the driving transistor DRT is electrically connected to the first node N1, and a gate voltage Vg may be applied thereto. The drain electrode or the source electrode of the driving transistor DRT may be electrically connected to the second node N2. The source electrode or the drain electrode of the driving transistor DRT may be electrically connected to the third node N3.

The first emission control transistor EMT1 may control a connection of a path through which the driving current flows, and may play a role in controlling an emission of the light emitting device ED.

If the driving transistor DRT and the first emission control transistor EMT1 are turned on between a high potential voltage VDD and a low potential voltage VSS, the driving current can be supplied to the light emitting device ED through the driving transistor DRT and the first emission control transistor EMT1. Accordingly, the light emitting device ED can emit light.

The first emission control transistor EMT1 is connected between the third node N3 and the fourth node N4, and can control the connection between the third node N3 and the fourth node N4 according to a first emission control signal EM1. The first emission control signal EM1 may be applied to the gate electrode of the first emission control transistor EMT1. The drain electrode or the source electrode of the first emission control transistor EMT1 may be electrically connected to the third node N3. The source electrode or drain electrode of the first emission control transistor EMT1 may be electrically connected to the fourth node N4.

The first emission control signal EM1 may be a pulse width modulation signal that varies at a predefined time (for example, each frame, or each sub-frame included in one frame), but the embodiments of the present disclosure are not limited thereto.

The first emission control signal EM1 may be generated by the driver DRV, or may be supplied to the driver DRV from a driving-related circuit such as a timing controller. For example, if the first emission control signal EM1 is a pulse width modulation signal, the first emission control signal EM1 may have a pulse width corresponding to an image signal (e.g., data voltage, data signal). For example, if the pulse width of the first t emission control signal EM1 is large, the luminance of the light emitting element ED may be high. If the pulse width of the first emission control signal EM1 is small, the luminance of the light emitting element ED may be low.

The row driver R-DRV may drive at least one row line RL by supplying a low-potential voltage VSS to at least one row line RL.

The row driver R-DRV may perform display-on driving or display-off driving for one row line RL. The row driver R-DRV may supply a low-potential voltage for display-on driving to one row line RL in order to perform display-on driving for one row line RL. The row driver R-DRV may supply a low-potential voltage for display-off driving to one row line RL in order to perform display-off driving for one row line RL.

A low-potential voltage for display-on driving and a low-potential voltage for display-off driving may be different. For example, the low-potential voltage for display-on driving may be lower than the low-potential voltage for display-off driving. In the embodiments of the present disclosure, the "low-potential voltage for display-on driving" is also referred to as the "first low-potential voltage," and the "low-potential voltage for display-off driving" is also referred to as the "second low-potential voltage."

The column driver C-DRV may further include at least one switching element and/or at least one transistor in addition to the driving transistor DRT and the first emission control transistor EMT1. Each of the transistors included in the column driver C-DRV may be an n-type transistor or a p-type transistor.

The column driver C-DRV may further include at least one capacitor. The column driver C-DRV may further include at least one circuit element. For example, the at least one circuit element may include a power output buffer.

The row driver R-DRV may include at least one switching element and/or at least one transistor. Each of the transistors included in the row driver R-DRV may be an n-type transistor or a p-type transistor. The row driver R-DRV may further include at least one circuit element. For example, at least one circuit element may include a power output buffer.

A part or all of the column driver C-DRV and the row driver R-DRV may be internal circuits included in the driver DRV. As another example, a part or all of the column driver C-DRV and the row driver R-DRV may not be included in the driver DRV and may be circuits formed on the substrate 210 of the display panel 110.

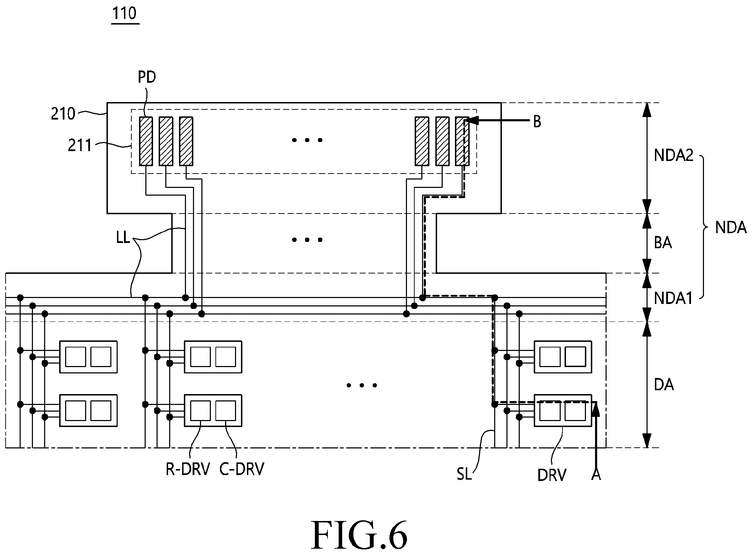

FIG. 6 is a plan view of the display panel 110 according to the embodiments of the present disclosure.

The substrate 210 of the display panel 110 according to the embodiments of the present disclosure may include a display area DA and a non-display area NDA, and the non-display area NDA may include a first non-display area NDA1, a bending area BA, and a second non-display area NDA2.

A plurality of drivers DRV may be arranged in the display area DA. Each of the plurality of drivers DRV may be a circuit for driving light emitting devices of a plurality of sub-pixels included in a corresponding unit driving area (UDA of FIG. 4). Each of the plurality of drivers DRV may include a row driver R-DRV for driving a plurality of row lines and a column driver C-DRV for driving a plurality of column lines, in order to drive a plurality of light emitting devices ED included in a corresponding unit driving area (UDA of FIG. 4).

A pad section 211 including a plurality of pads PD may be disposed in the second non-display area NDA2.

A plurality of signal lines SL and a plurality of link lines LL for signal transmission between a plurality of drivers DRV arranged in the display area DA and the pad section 211 may be arranged on the substrate 210. The plurality of signal lines SL may be electrically connected between the plurality of link lines LL and the plurality of drivers DRV. The plurality of link lines LL may electrically connect the plurality of pads PD and the plurality of signal lines SL.

The plurality of link lines LL may be arranged in the non-display area NDA, and all or part of each of the plurality of signal lines SL may be arranged in the display area DA.

Each of the plurality of drivers DRV may receive various signals to perform a driving operation through the plurality of link lines LL and the plurality of signal lines SL. Here, the various signals may include various power voltages and various signals required for the driving operation of each of the plurality of drivers DRV.

As the bending area BA is bent, a portion of the plurality of link lines LL may also be bent. Stress may be concentrated on a portion of the bent link line LL, and thus cracks may occur in the link line LL. Accordingly, the plurality of link lines LL may be formed of a conductive material having excellent ductility to reduce cracks when the bending area BA is bent. In addition, the plurality of link lines LL may include one of various conductive materials used in the display area DA. For example, the plurality of link lines LL may include molybdenum (Mo), chrome (Cr), titanium (Ti), nickel (Ni), neodymium (Nd), copper (Cu), and an alloy of silver (Ag) and magnesium (Mg) or an alloy thereof, but the example embodiments of the present disclosure are not limited thereto. The plurality of link lines LL may include a multilayer structure (such as a double layer structure or a triple layer structure) including various conductive materials. The plurality of link lines LL may include various shapes to reduce stress. At least a portion of the plurality of link lines LL arranged on the bending area BA may extend in the same direction as the extension direction of the bending area BA, or may extend in a direction different from the extension direction of the bending area BA to reduce stress. For example, at least a part of the plurality of link lines LL disposed on the bending area BA may have a shape in which a conductive pattern having at least one shape of a diamond shape, a rhombus shape, a trapezoidal wave shape, a triangular wave shape, a sawtooth wave shape, a sine wave shape, a circular shape, an omega (Ω) shape is repeatedly disposed. However, the example embodiments of the present disclosure are not limited thereto. Accordingly, in order to minimize or reduce a stress concentrated on the plurality of link lines LL and a crack caused thereby, a shape of the plurality of link lines LL may be various shapes including the above-mentioned shapes, but the example embodiments of the present disclosure are not limited thereto.

Hereinafter, in order to describe the planar structure of the display panel 110 according to the embodiments of the present disclosure in more detail, it will be described a planar structure of a portion 1100 of the planar view of FIG. 4 in more detail as an example.

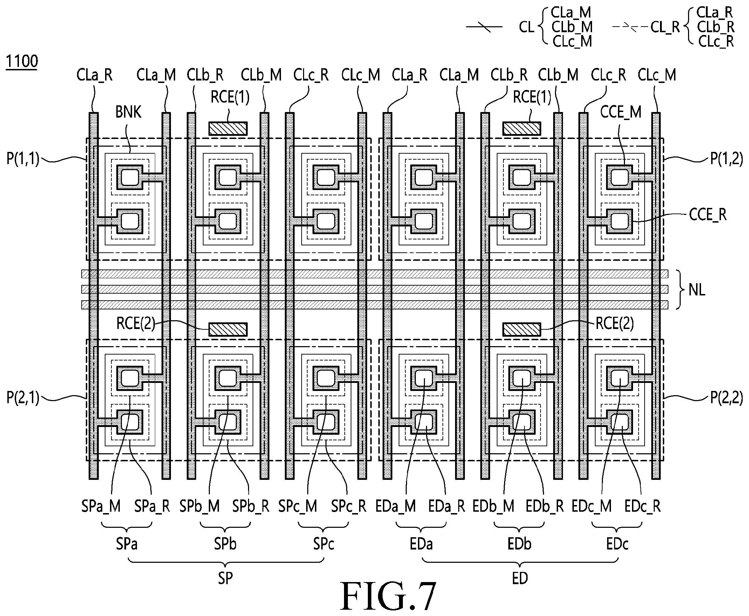

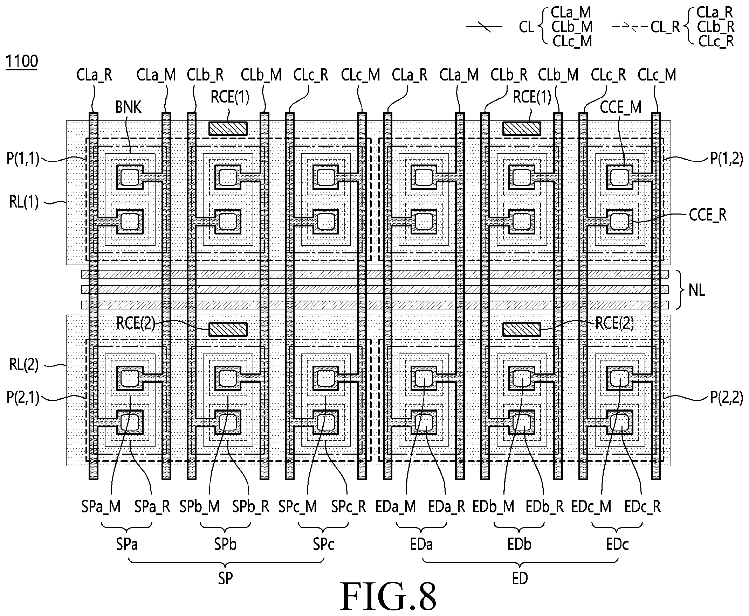

FIG. 7 and FIG. 8 are plan views of a portion 1100 of a display panel 110 according to embodiments of the present disclosure. FIG. 7 and FIG. 8 are enlarged plan views of a portion 1100 of the plan view of FIG. 4, and are enlarged plan views of a two-row, two-column area 1100.

FIG. 7 is a plan view that does not show two row lines RL(1) and RL(2) arranged in a two-row, two-column area 1100, and FIG. 8 is a plan view that adds two row lines RL(1) and RL(2) arranged in a two-row, two-column area 1100 to the plan view of FIG. 8.

In the two-row, two-column area 1100, four pixels P(1,1), P(1,2), P(2, 1), P(2,2) may be arranged in two rows and two columns. For example, in the two-row, two-column area 1100, two pixels P(1,1) and P(1,2) may be arranged in a first row (e.g., a first pixel row), and two pixels P(2,1) and P(2,2) may be arranged in a second row (e.g., a second pixel row). In addition, two pixels P(1,1) and P(2,1) may be arranged in a first column (e.g., a first pixel column), and two pixels P(1,2) and P(2,2) may be arranged in a second column (e.g., a second pixel column).

In the two-row, two-column area 1100, each of the four pixels P(1, 1), P(1,2), P(2, 1) and P(2,2) arranged in two rows and two columns may include k sub-pixels. Here, k is the number of sub-pixels included in one pixel.

In FIG. 7 and FIG. 8, it is exemplified a case where k is 3 as an example. Accordingly, in the two-row, two-column area 1100, each of the four pixels P(1,1), P(1,2), P(2, 1) and P(2,2)) arranged in two rows and two columns may include three sub-pixels SPa, SPb and SPc, but the present disclosure is not limited thereto, and more or less sub-pixels may be included in each pixel. In the following description, it is described a case where k is 3.

The three sub-pixels may include a first sub-pixel SPa including a first light emitting device EDa that emits a first color light, a second sub-pixel SPb including a second light emitting device EDb that emits a second color light, and a third sub-pixel SPc including a third light emitting device EDc that emits a third color light.

If the display panel 110 according to the embodiments of the present disclosure has a redundancy structure, the sub-pixel redundancy structure is as follows. The first sub-pixel SPa may include a first main sub-pixel SPa_M including a first main light emitting device EDa_M and a first redundancy sub-pixel SPa_R including a first redundancy light emitting device EDa_R. The second sub-pixel SPb may include a second main sub-pixel SPb_M including a second main light emitting device EDb_M and a second redundancy sub-pixel SPb_R including a second redundancy light emitting device EDb_R. The third sub-pixel SPc may include a third main sub-pixel SPc_M including a third main light emitting device EDc_M and a third redundancy sub-pixel SPc_R including a third redundancy light emitting device EDc_R.

If the display panel 110 according to the embodiments of the present disclosure has a redundancy structure, the light emitting device redundancy structure is as follows. The first light emitting device EDa may include a first main light emitting device EDa_M that emits a first color light and a first redundancy light emitting device EDa_R that emits a first color light. The second light emitting device EDb may include a second main light emitting device EDb_M that emits a second color light and a second redundancy light emitting device EDb_R that emits a second color light. The third light emitting device EDb may include a third main light emitting device EDc_M that emits a third color light and a third redundancy light emitting device EDc_R that emits a third color light.

In the two-row, two-column area 1100, a first row line RL(1) and a second row line RL(2) may be arranged. The first row line RL(1) may be arranged in the first row (e.g., the first pixel row), and the second row line RL(2) may be arranged in the second row (e.g., the second pixel row).

In the area where the first row line RL(1) is arranged, there may be arranged a first main sub-pixel SPa_M, a first redundancy sub-pixel SPa_R, a second main sub-pixel SPb_M, a second redundancy sub-pixel SPb_R, a third main sub-pixel SPc_M, and a third redundancy sub-pixel SPc_R in the first row (first pixel row).

The first row line RL(1) may be connected to the second electrode Erl of each of the first main light emitting device EDa_M, the first redundancy light emitting device EDa_R, the second main light emitting device EDb_M, the second redundancy light emitting device EDb_R, the third main light emitting device EDc_M, and the third redundancy light emitting device EDc_R arranged in the first row (or the first pixel row).

At least a portion of the first row line RL(1) may overlap with the first main light emitting device EDa_M, the first redundancy light emitting device EDa_R, the second main light emitting device EDb_M, the second redundancy light emitting device EDb_R, the third main light emitting device EDc_M, and the third redundancy light emitting device EDc_R arranged in the first row (or the first pixel row).

In the area where the second row line RL(2) is arranged, there may be arranged a first main sub-pixel SPa_M, a first redundancy sub-pixel SPa_R, a second main sub-pixel SPb_M, a second redundancy sub-pixel SPb_R, a third main sub-pixel SPc_M, and a third redundancy sub-pixel SPc_R in the second row (second pixel row).

The second row line RL(2) may be connected to the second electrode Erl of each of the first main light emitting device EDa_M, the first redundancy light emitting device EDa_R, the second main light emitting device EDb_M, the second redundancy light emitting device EDb_R, the third main light emitting device EDc_M, and the third redundancy light emitting device EDc_R arranged in the second row (or the second pixel row).

At least a portion of the second row line RL(2) may overlap with the first main light emitting device EDa_M, the first redundancy light emitting device EDa_R, the second main light emitting device EDb_M, the second redundancy light emitting device EDb_R, the third main light emitting device EDc_M, and the third redundancy light emitting device EDc_R arranged in the second row (or the second pixel row).

A plurality of first column lines CL arranged in a first column (or first pixel column) may include a first main column line CLa_M that is commonly connected to a first main sub-pixel SPa_M included in each of two pixels P(1,1)and P(2,1) arranged in the first column (or first pixel column), and a first redundancy column line CLa_R that is commonly connected to a first redundancy sub-pixel SPa_R included in each of two pixels P(1,1) and P(2,1) arranged in the first column (or first pixel column).

The first main column line CLa_M arranged in the first column (or the first pixel column) may be commonly connected to the first electrodes Ecl of the two first main light emitting devices EDa_M arranged in the first column (or the first pixel column).

The first redundancy column line CLa_R arranged in the first column (or the first pixel column) may be commonly connected to the first electrodes Ecl of two first redundancy light emitting devices EDa_R arranged in the first column (or the first pixel column).

In addition, the plurality of first column lines CL arranged in the first column (or the first pixel column) may further include a second main column line CLb_M commonly connected to a second main sub-pixel SPb_M included in each of the two pixels P(1,1) and P(2, 1) arranged in the first column (or the first pixel column), and a second redundancy column line CLb_R commonly connected to a second redundancy sub-pixel SPb_R included in each of the two pixels P(1,1) and P(2,1) arranged in the first column (or the first pixel column).

The second main column line CLb_M arranged in the first column (or the first pixel column) may be commonly connected to the first electrodes Ecl of the two second main light emitting devices EDb_M arranged in the first column (or the first pixel column).

The second redundancy column line CLb_R arranged in the first column (or the first pixel column) may be commonly connected to the first electrodes Ecl of the two second redundancy light emitting devices EDb_R arranged in the first column (or the first pixel column).

In addition, the plurality of first column lines CL arranged in the first column (or the first pixel column) may further include a third main column line CLc_M commonly connected to the third main sub-pixel SPc_M included in each of the two pixels P(1, 1) and P(2, 1) arranged in the first column (or the first pixel column), and a third redundancy column line CLc_R commonly connected to the third redundancy sub-pixel SPc_R included in each of the two pixels P(1,1) and P(2,1) arranged in the first column (or the first pixel column).

The third main column line CLc_M arranged in the first column (or the first pixel column) may be commonly connected to the first electrodes Ecl of the two third main light emitting devices EDc_M arranged in the first column (or the first pixel column).

The third redundancy column line CLc_R arranged in the first column (or the first pixel column) may be commonly connected to the first electrodes Ecl of two third redundancy light emitting devices EDc_R arranged in the first column (or the first pixel column).

A plurality of second column lines CL arranged in a second column (or second pixel column) may include a first main column line CLa_M that is commonly connected to a first main sub-pixel SPa_M included in each of two pixels P(1,2) and P(2,2) arranged in the second column (or second pixel column), and a first redundancy column line CLa_R that is commonly connected to a first redundancy sub-pixel SPa_R included in each of two pixels P(1,2) and P(2,2) arranged in the second column (or second pixel column).

The first main column line CLa_M arranged in the second column (or the second pixel column) may be commonly connected to the first electrodes Ecl of the two first main light emitting devices EDa_M arranged in the second column (or the second pixel column).

The first redundancy column line CLa_R arranged in the second column (or the second pixel column) may be commonly connected to the first electrodes Ecl of the two first redundancy light emitting devices EDa_R arranged in the second column (or the second pixel column).

In addition, the plurality of second column lines CL arranged in the second column (second pixel column) may further include a second main column line CLb_M commonly connected to a second main sub-pixel SPb_M included in each of two pixels P(1,2) and P(2,2) arranged in the second column (or second pixel column), and a second redundancy column line CLb_R commonly connected to a second redundancy sub-pixel SPb_R included in each of two pixels P(1,2) and P(2,2) arranged in the second column (or second pixel column).

The second main column line CLb_M arranged in the second column (or the second pixel column) may be commonly connected to the first electrodes Ecl of the two second main light emitting devices EDb_M arranged in the second column (or the second pixel column).

The second redundancy column line CLb_R arranged in the second column (or the second pixel column) may be commonly connected to the first electrodes Ecl of two second redundancy light emitting devices EDb_R arranged in the second column (or the second pixel column).

In addition, the plurality of first column lines CL arranged in the second column (or the second pixel column) may further include a third main column line CLc_M commonly connected to a third main sub-pixel SPc_M included in each of two pixels P(1,2) and P(2,2) arranged in the second column (or the second pixel column), and a third redundancy column line CLc_R commonly connected to a third redundancy sub-pixel SPc_R included in each of two pixels P(1,2) and P(2,2) arranged in the second column (or the second pixel column).

The third main column line CLc_M arranged in the second column (or the second pixel column) may be commonly connected to the first electrodes Ecl of the two third main light emitting devices EDc_M arranged in the second column (or the second pixel column).

The third redundancy column line CLc_R arranged in the second column (or the second pixel column) may be commonly connected to the first electrodes Ecl of two third redundancy light emitting devices EDc_R arranged in the second column (or the second pixel column).

The main column connection electrodes CCE_M and the redundancy column connection electrodes CCE_R arranged in the first column (or the first pixel column) may be disposed between the first main column line CLa_M and the first redundancy column line CLa_R.

The main column connection electrodes CCE_M and the redundancy column connection electrodes CCE_R arranged in the second column (or the second pixel column) may be disposed between the second main column line CLb_M and the second redundancy column line CLb_R.

The main column connection electrodes CCE_M and the redundancy column connection electrodes CCE_R arranged in the third column (or the third pixel column) may be disposed between the third main column line CLc_M and the third redundancy column line CLc_R.

The display panel 110 according to the embodiments of the present disclosure may further include at least one row connection electrode for electrically connecting each of the plurality of row lines RL to the driver DRV.

The display panel 110 according to the embodiments of the present disclosure may further include at least one first row connection electrode RCE(1) connected to a first row line RL(1) arranged in a first row (or a first pixel row), and at least one second row connection electrode RCE(2) connected to a second row line RL(2) arranged in a second row (or a second pixel row).

The first row line RL(1) may be vertically overlapped with at least one first row connection electrode RCE(1), and the second row line RL(2) may be vertically overlapped with at least one second row connection electrode RCE(2).

The first row line RL(1) may be electrically connected to the row driver R-DRV of the corresponding driver DRV through at least one first row connection electrode RCE(1). The second row line RL(2) may be electrically connected to the row driver R-DRV of the corresponding driver DRV through at least one second row connection electrode RCE(2).

A bank BNK may be disposed in each of a plurality of sub-pixels SP. The plurality of banks BNK may be structures on which a plurality of light emitting devices ED are mounted. When manufacturing a panel, in a transfer process for transferring a plurality of light emitting devices ED to a display device 100, a plurality of banks BNK can guide the positions of the plurality of light emitting devices ED. For example, when manufacturing a panel, a plurality of light emitting devices ED can be transferred onto a plurality of banks BNK in a transfer process of the plurality of light emitting devices ED. The plurality of banks BNK may be an organic insulating layer, a bank pattern, or a structure, but the embodiments of the present disclosure are not limited thereto.

The banks BNK of each of the plurality of sub-pixels SP may be arranged to be spaced apart from each other. The banks BNK of each of the plurality of sub-pixels SP may be configured to be separated from each other. For example, the banks BNK of each of the plurality of sub-pixels SP may be formed as an island shape. Accordingly, the banks BNK of the first sub-pixel SPa, the second sub-pixel SPb, and the third sub-pixel SPc to which different types of light emitting devices ED are transferred can be easily identified.

The bank BNK of the first main sub-pixel SPa_M and the bank BNK of the first redundancy sub-pixel SPa_R may be connected to each other, or may be formed spaced apart from each other or separately. For example, considering the design of the transfer process requirements, the bank BNK of the first main sub-pixel SPa_M and the bank BNK of the first redundancy sub-pixel SPa_R, in which light emitting devices EDa_M, EDa_R of the same type (for example, types that emit the same color light) are arranged, may be connected to each other, or may be formed spaced apart from each other or separately. In addition, the bank BNK of the second main sub-pixel SPb_M and the bank BNK of the second redundancy sub-pixel SPb_R may be connected to each other, or may be formed spaced apart from each other or separately. The bank BNK of the third main sub-pixel SPc_M and the bank BNK of the third redundancy sub-pixel SPc_R may be connected to each other, or may be formed to be spaced apart from each other or separated from each other.

The bank BNK of the first main sub-pixel SPa_M and the first redundancy sub-pixel SPa_R, the bank BNK of the second main sub-pixel SPb_M and the second redundancy sub-pixel SPb_R, and the bank BNK of the third main sub-pixel SPc_M and the third redundancy sub-pixel SPc_R may be formed in various ways, and the embodiments of the present disclosure are not limited thereto.

For example, the plurality of banks BNK may be formed of an organic insulating material. The plurality of banks BNK may be formed of a single layer or multiple layers of an organic insulating material. For example, the plurality of banks BNK may include a photo resist, a polyimide (PI), or an acrylic material.

The plurality of row lines RL may be formed of a transparent conductive material, but the embodiments of the present disclosure are not limited thereto. The plurality of row lines RL may include a transparent conductive material so that light emitted from the light emitting devices ED may be directed upward through the row lines RL. For example, the plurality of row lines RL may include a transparent conductive material such as indium tin oxide (ITO), indium zinc oxide (IZO), indium gallium zinc oxide (IGZO), and the like.

The plurality of column lines CL may be made of a conductive material. For example, the plurality of column lines CL may be formed of a conductive material such as titanium (Ti), aluminum (Al), copper (Cu), molybdenum (Mo), nickel (Ni), chromium (Cr), indium tin oxide (ITO), indium zinc oxide (IZO), indium gallium zinc oxide (IGZO), but the embodiments of the present disclosure are not limited thereto. For another example, the plurality of column lines CL may have a multilayer structure of conductive materials. For example, the plurality of column lines CL may be made of a multilayer structure of titanium (Ti)/aluminum (Al)/titanium (Ti)/indium tin oxide (ITO).

For example, if the light emitting device ED is a device manufactured through a semiconductor process, such as a micro LED, a plurality of light emitting devices ED may be formed on a wafer and the light emitting devices ED may be transferred to a substrate 210 of the display panel 110 to manufacture the display panel 110. In the process of transferring a plurality of light emitting devices ED having a microscopic size from the wafer to the substrate 210, various defects may occur. For example, a non-transfer defect may occur in which the light emitting device ED is not transferred in some sub-pixels SP, and a misalignment defect may occur in which the light emitting device ED is transferred out of its proper position due to an alignment error in other sub-pixels SP. In addition, the transfer process may proceed normally, but the transferred light emitting device ED itself may have a defect. Therefore, considering the defects (including non-transfer defects) that occur during the transfer process of the light emitting devices EDs, the main light emitting device and the redundancy light emitting device, which are light emitting devices of the same type (e.g., light emitting devices that emit light of the same color), can be transferred to one sub-pixel SP. A lighting test may be performed on the main light emitting device and the redundancy light emitting device of the same type, and it is possible to utilize one of the main light emitting device and the redundancy light emitting device that is finally determined to be normal.

For example, the first main light emitting device EDa_M and the first redundancy light emitting device EDa_R may be transferred together to one first sub-pixel SPa, and the first main light emitting device EDa_M and the first redundancy light emitting device EDa_R may be inspected for defects. If, as a result of the inspection, both the first main light emitting device EDa_M and the first redundancy light emitting device EDa_R are determined to be normal, only the first main light emitting device EDa_M can be used, and the first redundancy light emitting device EDa_R may be not used. If, as a result of the inspection, only the first redundancy light emitting device EDa_R among the first main light emitting device EDa_M and the first redundancy light emitting device EDa_R is normal, the first main light emitting device EDa_M is not used, and the first redundancy light emitting device EDa_R can be used. Accordingly, even if the same first main light emitting device EDa_M and the first redundancy light emitting device EDa_R are transferred to one first sub-pixel SPa, one of the first main light emitting device EDa_M and the first redundancy light emitting device EDa_R can be used finally.

Accordingly, among the main light emitting device and the redundancy light emitting device arranged in one sub-pixel SP, the redundancy light emitting device may be a spare light emitting device transferred in preparation for a failure of the main light emitting device. In the event of a failure of the main light emitting device, the redundancy light emitting device can be used as a replacement. Therefore, by transferring the main light emitting device and the redundancy light emitting device together to one sub-pixel SP, it is possible to minimize or reduce the deterioration of display quality due to a defect in one of the main light emitting device and the redundancy light emitting device.

In the embodiments of the present disclosure, the first main sub-pixel SPa_M and the first redundancy sub-pixel SPa_R may also be referred to as a 1-1 sub-pixel and a 1-2 sub-pixel, respectively, the second main sub-pixel SPb_M and the second redundancy sub-pixel SPb_R may also be referred to as a 2-1 sub-pixel and a 2-2 sub-pixel, and the third main sub-pixel SPc_M and the third redundancy sub-pixel SPc_R may also be referred to as a 3-1 sub-pixel and a 3-2 sub-pixel, respectively.

In the embodiments of the present disclosure, the first main light emitting device EDa_M and the first redundancy light emitting device EDa_R may also be referred to as a 1-1 light emitting device and a 1-2 light emitting device, the second main light emitting device EDb_M and the second redundancy light emitting device EDb_R may also be referred to as a 2-1 light emitting device and a 2-2 light emitting device, and the third main light emitting device EDc_M and the third redundancy light emitting device EDc_R may also be referred to as a 3-1 light emitting device and a 3-2 light emitting device.

The display panel 110 according to the embodiments of the present disclosure may further include a plurality of communication lines NL. The plurality of communication lines NL may be arranged so as not to overlap with the conductive layer in a vertical direction. For example, a plurality of communication lines NL may be arranged between a first row line RL(1) and a second row line RL(2).

For example, the plurality of communication lines NL may be wires for short-range communication such as NFC (Near Field Communication) and Bluetooth. The plurality of communication lines NL may serve as signal transmission wires and/or antennas. For example, the plurality of communication lines NL may be a plurality of connection lines, but the example embodiments of the present disclosure are not limited thereto.

Referring to FIG. 8, each of the first row line RL(1) and the second row line RL(2) may be arranged above a plurality of light emitting devices, and may be arranged in a bar or stripe shape overlapping with all of the plurality of light emitting devices. It is to be noted that although it is shown in FIGs. 4 and 8-9 that in the arrangement of the subpixels, the main sub-pixels are disposed in a same row, while the redundancy sub-pixels are disposed in another same row, the present disclosure is not limited thereto. For example, within one pixel, one of the main sub-pixels (for example, the second main sub-pixel) may be disposed in a row where the first redundancy sub-pixel and the third redundancy sub-pixel are disposed and one of the redundancy sub-pixels (for example, the second redundancy sub-pixel) may be disposed in a row where the first main sub-pixel and the third main sub-pixel are disposed.

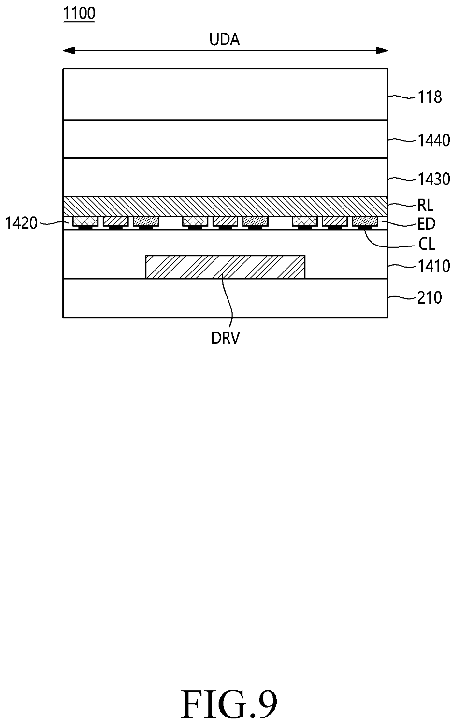

FIG. 9 is a cross-sectional view of a display panel 110 according to embodiments of the present disclosure. For example, FIG. 9 is a cross-sectional view of a portion of a unit driving area UDA in which one driver DRV is arranged.

Referring to FIG. 9, a display panel 110 may include a substrate 210, a driver DRV on the substrate 210, a layer stack 1410 on the driver DRV, a plurality of light emitting devices ED disposed on the layer stack 1410, an optical layer 1420 disposed on the layer stack 1410 and between the plurality of light emitting devices ED, an overcoat layer 1430 disposed on the plurality of light emitting devices ED and the optical layer 1420, an adhesive layer 1440 disposed on the overcoat layer 1430, and a cover member 118 disposed on the adhesive layer 1440.

A plurality of column lines CL may be arranged on a layer stack 1410. Each of the plurality of column lines CL may be arranged between the layer stack 1410 and a light emitting device ED. A plurality of row lines RL may be arranged on a plurality of light emitting devices ED and an optical layer 1420.

A display panel 110 may include a substrate 210 including a display area DA, a plurality of light emitting devices ED arranged in the display area DA, a plurality of column lines CL electrically connected to first electrodes Ecl of each of the plurality of light emitting devices ED, a plurality of row lines RL electrically connected to second electrodes Erl of each of the plurality of light emitting devices ED, and a plurality of drivers DRV configured to drive the plurality of light emitting devices ED, the plurality of column lines CL, and the plurality of row lines RL.

A plurality of drivers DRV may be arranged in the display area DA, and may be positioned closer to the substrate 210 than the plurality of light emitting devices ED.

The layer stack 1410 may include a plurality of insulating layers. The plurality of insulating layers may include a plurality of organic layers. At least one of the plurality of organic layers may be arranged on a side of the driver DRV. For example, two or more organic layers may be arranged on a side of the driver DRV.

The layer stack 1410 may further include at least one conductive layer connecting the driver DRV and the column line CL, and at least one conductive layer connecting the driver DRV and the row line RL.

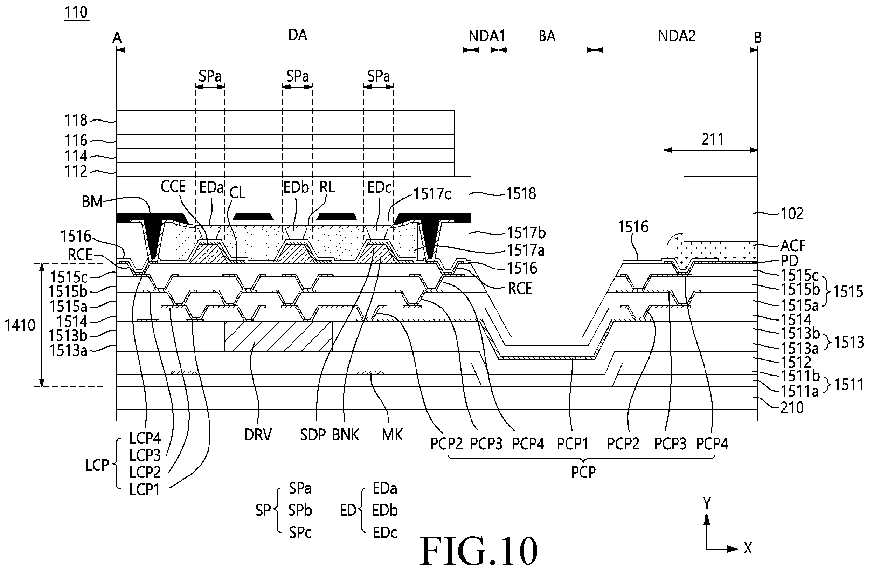

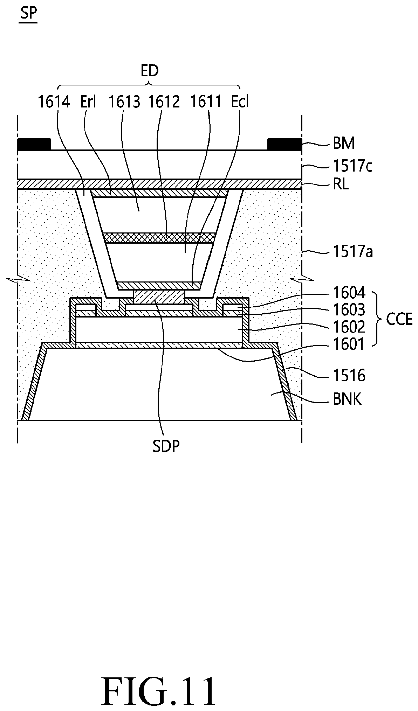

FIG. 10 is a detailed cross-sectional view of a display panel 110 according to embodiments of the present disclosure taken along the A-B cutting line of FIG. 6, and FIG. 11 is an enlarged cross-sectional view of a first sub-pixel SP of a display panel 110 according to embodiments of the present disclosure. For example, FIG. 10 is a cross-sectional view of a display area DA, a first non-display area NDA1, a bending area BA, and a second non-display area NDA2.

In addition, for convenience of illustration, the A-B cutting line in FIG. 6 is illustrated as not overlapping with a signal line SL and a link line LL, but the A-B cutting line in FIG. 6 is intended to indicate the same position as the adjacent signal line SL and the link line LL.

A buffer layer 1511 may be disposed on the substrate 210. The buffer layer 1511 may include a first buffer layer 1511a and a second buffer layer 1511b. The first buffer layer 1511a and the second buffer layer 1511b may be arranged in the display area DA, the first non-display area NDA1, and the second non-display area NDA2, and may not be arranged in the entirety or part of the bending area BA.

The first buffer layer 1511a and the second buffer layer 1511b may reduce the penetration of moisture or impurities through the substrate 210. The first buffer layer 1511a and the second buffer layer 1511b may be made of an inorganic insulating material. For example, the first buffer layer 1511a and the second buffer layer 1511b may include a single layer or multiple layers of silicon oxide (SiOx) or silicon nitride (SiNx).

For example, a portion of the first buffer layer 1511a and the second buffer layer 1511b on the bending area BA may be removed. The upper surface of the substrate 210 located on the bending area BA may be exposed by the area (e.g., opening) where the first buffer layer 1511a and the second buffer layer 1511b are removed.

By removing the first buffer layer 1511a and the second buffer layer 1511b from the bending area BA, it is possible to minimize or reduce an occurrence of cracks in the first buffer layer 1511a and the second buffer layer 1511b that may occur during bending.

A plurality of alignment keys MK may be arranged between the first buffer layer 1511a and the second buffer layer 1511b. The plurality of alignment keys MK may be configured to identify the position of the driver DRV during the manufacturing process of the display panel 110. For example, the plurality of alignment keys MK may be configured to align the position of the driver DRV transferred on the adhesive layer 1512. In another example, the plurality of alignment keys MK may be omitted.

An adhesive layer 1512 may be disposed on the second buffer layer 1511b. The adhesive layer 1512 may be disposed in the display area DA, the first non-display area NDA1, the bending area BA, and the second non-display area NDA2. For another example, at least a portion of the adhesive layer 1512 may be removed in the non-display area NDA including the bending area BA. For example, the adhesive layer 1512 may be made of any one of an adhesive polymer, an epoxy resin, a UV-curable resin, a polyimide series, an acrylate series, a urethane series, and a polydimethylsiloxane (PDMS).

A driver DRV may be disposed on the adhesive layer 1512 in the display area DA. If the driver DRV is implemented as a driving chip (e.g., driver integrated circuit), the driving driver may be mounted on the adhesive layer 1512 by a transfer process.

The display panel 110 may further include a side protection layer 1513 disposed on the side of the plurality of drivers DRV, and an upper protection layer 1514 disposed on the plurality of drivers DRV and the side protection layer 1513. For example, the side protection layer 1513 may include at least one of a first protection layer 1513a and a second protection layer 1513b disposed on the side of the plurality of drivers DRV, and in some cases, may further include at least one additional protection layer. The first protection layer 1513a and the second protection layer 1513b may be disposed on the adhesive layer 1512. The first protection layer 1513a and the second protection layer 1513b may be arranged to surround the side surface of the driver DRV. For example, the second protection layer 1513b may be arranged to cover at least a portion of the upper surface of the driver DRV. For example, at least one of the first protection layer 1513a and the second protection layer 1513b arranged on the bending area BA may be omitted. For example, the first protection layer 1513a may be arranged entirely on the display area DA and the non-display area NDA, and the second protection layer 1513b may be partially arranged on the display area DA, the first non-display area NDA1, and the second non-display area NDA2. For example, at least a portion of the second protection layer 1513b may be removed in all or part of the bending area BA.

For example, the side protection layer 1513 including at least one of the first protection layer 1513a and the second protection layer 1513b may include an organic insulating material (e.g., organic layer), but the embodiments of the present disclosure are not limited thereto. For example, the first protection layer 1513a and the second protection layer 1513b may include a photo resist, a polyimide (PI), or a photo acryl-based material. For example, the first protection layer 1513a and the second protection layer 1513b may be an overcoating layer or an insulating layer.

The display panel 110 may further include a plurality of insulating layers 1515 disposed on the upper protection layer 1514. For example, the plurality of insulating layers 1515 may include a first insulating layer 1515a, a second insulating layer 1515b, and a third insulating layer 1515c.

In the display area DA, a plurality of line connection patterns LCP may be arranged on the second protection layer 1513b. The plurality of line connection patterns LCP may be wiring for electrically connecting the driver DRV to other components. For example, the driver DRV may be electrically connected to a plurality of column lines CL, a plurality of row lines RL, and a plurality of row connection electrodes RCE through the plurality of line connection patterns LCP.

For example, the plurality of line connection patterns LCP may include a first line connection pattern LCP1, a second line connection pattern LCP2, a third line connection pattern LCP3, and a fourth line connection pattern LCP4. For example, the first line connection pattern LCP1, the second line connection pattern LCP2, the third line connection pattern LCP3, and the fourth line connection pattern LCP4 may be arranged in different conductive layers (for example, metal layers).

For example, a plurality of first line connection patterns LCP1 may be arranged on the second protection layer 1513b. The plurality of first line connection patterns LCP1 may be electrically connected to the driver DRV. The plurality of first line connection patterns LCP1 may transmit the voltage or signal output from the driver DRV to the column line CL or the row line RL.

The display panel 110 may further include a side protection layer 1513 including at least one of the first protection layer 1513a and the second protection layer 1513b, and an upper protection layer 1514 arranged on the plurality of drivers DRV. For example, the upper protection layer 1514 may include a third protection layer 1514, and in some cases, may further include at least one additional protection layer. The third protection layer 1514 may be disposed on the second protection layer 1513b and the plurality of first line connection patterns LCP1. The third protection layer 1514 may be disposed entirely in the display area DA and the non-display area NDA. In the bending area BA, the third protection layer 1514 may cover, surround or enclose the side surface of the second protection layer 1513b and the upper surface of the first protection layer 1513a.

For example, the third protection layer 1514 may include an organic insulating material. For example, the third protection layer 1514 may include a photo resist, a polyimide (PI), or a photo acryl-based material. For example, the first protection layer 1513a, the second protection layer 1513b, and the third protection layer 1514 may include the same insulating material, or at least one of the first protection layer 1513a, the second protection layer 1513, and the third protection layer 1514 may include a different insulating material from the rest.

A plurality of second line connection patterns LCP2 may be arranged on the third protection layer 1514. The plurality of second line connection patterns LCP2 may be electrically connected or directly connected to the driver DRV. For example, some of the second line connection patterns LCP2 may be directly or indirectly connected to the driver DRV through contact holes of the third protection layer 1514. Other parts of the second line connection patterns LCP2 may be electrically connected to the first line connection pattern LCP1 through contact holes of the third protection layer 1514. However, the embodiments of the present disclosure are not limited thereto. The voltage output from the driver DRV may be transmitted to the column line CL or the row line RL through the plurality of second line connection patterns LCP2 and other connection patterns.

A first insulating layer 1515a may be disposed on the plurality of second line connection patterns LCP2. The first insulating layer 1515a may be disposed entirely over the display area DA and the non-display area NDA. The first insulating layer 1515a may include an organic insulating material. For example, the first insulating layer 1515a may include a photo resist, a polyimide (PI), or a photo acryl-based material.

A plurality of third line connection patterns LCP3 may be disposed on the first insulating layer 1515a. The plurality of third line connection patterns LCP3 may be electrically connected to the plurality of second line connection patterns LCP2. For example, the third line connection pattern LCP3 may be electrically connected to the second line connection pattern LCP2 through a contact hole of the first insulating layer 1515a.

A second insulating layer 1515b may be disposed on a plurality of third line connection patterns LCP3. The second insulating layer 1515b may be disposed in the display area DA, the first non-display area NDA1, and the second non-display area NDA2, and may not be disposed in the entirety or part of the bending area BA, but the embodiments of the present disclosure are not limited thereto. For example, the second insulating layer 1515b may be removed from the entirety or part of the bending area BA. The second insulating layer 1515b may include an organic insulating material. For example, the second insulating layer 1515b may include a photo resist, a polyimide (PI), or a photo acryl-based material.

A plurality of fourth line connection patterns LCP4 may be arranged on the second insulating layer 1515b. The plurality of fourth line connection patterns LCP4 may be electrically connected to a plurality of third line connection patterns LCP3. For example, the fourth line connection patterns LCP4 may be electrically connected to the third line connection patterns LCP3 through a contact hole of the second insulating layer 1515b.

In the non-display area NDA, a plurality of pad connection patterns PCP may be arranged on the second protection layer 1513b. A plurality of pad connection patterns PCPs may be wiring for transmitting a signal transmitted from a flexible printed circuit 102 to a pad section 211 to a driver DRV of a display area DA. For example, a plurality of pad connection patterns PCP may be electrically connected to a plurality of pads PDs and may receive signals from the flexible printed circuit 102 through the plurality of pads PDs. The flexible printed circuit 102 may be connected to a printed circuit board 104 (see FIGS. 1 and 2).

For example, a plurality of pad connection patterns PCP may extend from the pad section 211 toward the display area DA and transmit signals to the wiring of the display area DA. In this case, a plurality of pad connection patterns PCP may function as link lines LL (see FIG. 6). The plurality of pad connection patterns PCP may include a first pad connection pattern PCP1, a second pad connection pattern PCP2, a third pad connection pattern PCP3, and a fourth pad connection pattern PCP4.

The plurality of first pad connection patterns PCP1 may be arranged on the second protection layer 1513b. Each of the plurality of first pad connection patterns PCP1 may be arranged across the second non-display area NDA2, the bending area BA, and the first non-display area NDA1. Each of the plurality of first pad connection patterns PCP1 may include a first portion arranged in the bending area BA, a second portion extending from the first portion to the first non-display area NDA1, and a third portion extending from the first portion to the second non-display area NDA2. Each of the plurality of first pad connection patterns PCP1 may extend from the first non-display area NDA1 to a portion of the display area DA. The plurality of first pad connection patterns PCP1 may transmit a signal transmitted from the flexible printed circuit 102 to the pad section 211 to the driver DRV of the display area DA.

Each of the plurality of first pad connection patterns PCP1 may be electrically connected to the pad PD of the pad section 211 through connection patterns arranged in the second non-display area NDA2. Here, the connection patterns electrically connecting each of the plurality of first pad connection patterns PCP1 to the pad PD may include at least one of the second pad connection pattern PCP2, the third pad connection pattern PCP3, and the fourth pad connection pattern PCP4 arranged in the second non-display area NDA2.

Each of the plurality of first pad connection patterns PCP1 may be electrically connected to the driver DRV through connection patterns arranged in the display area DA. Here, the connection patterns electrically connecting each of the plurality of first pad connection patterns PCP1 to the driver DRV may include at least one of the second pad connection pattern PCP2, the third pad connection pattern PCP3, and the fourth pad connection pattern PCP4 arranged in the display area DA.

The plurality of second pad connection patterns PCP2 may be arranged on the third protection layer 1514. The plurality of second pad connection patterns PCP2 may be arranged in the second non-display area NDA2. The second pad connection pattern PCP2 may be electrically connected to the first pad connection pattern PCP1 through a contact hole of the third protection layer 1514. Therefore, the signal supplied from the flexible printed circuit 102 can be transmitted to the first pad connection pattern PCP1 through the second pad connection pattern PCP.

The third pad connection pattern PCP3 may be arranged on the first insulating layer 1515a. The third pad connection pattern PCP3 may be arranged in the second non-display area NDA2. The third pad connection pattern PCP3 may be electrically connected to the second pad connection pattern PCP2 through a contact hole of the first insulating layer 1515a. Therefore, the signal supplied from the flexible printed circuit 102 can be transmitted to the second pad connection pattern PCP2 through the third pad connection pattern PCP3, and the signal transmitted to the second pad connection pattern PCP2 can be transmitted again to the first pad connection pattern PCP1.

The fourth pad connection pattern PCP4 may be arranged on the second insulating layer 1515b. The fourth pad connection patternPCP4) may be arranged in the second non-display area NDA2. The fourth pad connection pattern PCP4 may be electrically connected to the third pad connection pattern PCP3 through a contact hole of the second insulating layer 1515b. The pad PD of the pad section 211 may be electrically connected to the fourth pad connection pattern PCP4 through a contact hole of the third insulating layer 1515c.

A signal supplied from a flexible printed circuit 102 is input to a pad PD of a pad section 211, and a signal input to the pad PD is transmitted to a third pad connection pattern PCP3 through a fourth pad connection pattern PCP4, and a signal transmitted to the third pad connection pattern PCP3 can be transmitted again to a first pad connection pattern PCP1 through a second pad connection pattern PCP2. A signal transmitted to the first pad connection pattern PCP1 can be transmitted to a driver DRV through connection patterns arranged in a display area DA. In addition, as shown in FIG. 10, the first to fourth connection patterns PCP1 to PCP4 may be disposed on a same layer as the first to fourth line connection patterns LCP1 to LCP4 respectively. For example, the first to fourth connection patterns PCP1 to PCP4, and the first to fourth line connection patterns LCP1 to LCP4 may be respectively formed of same materials in a same mask process at the same time.

The plurality of line connection patterns LCP and a plurality of pad connection patterns PCP may be arranged in various conductive layers (for example, metal layers). The plurality of line connection patterns LCP and the plurality of pad connection patterns PCP may be formed of any one of a conductive material having excellent ductility or various conductive materials used in a display area DA.

For example, a metal pattern such as a first pad connection pattern PCP1 at least partially disposed in the bending area BA may include a conductive material having excellent ductility, such as gold (Au), silver (Ag), or aluminum (Al). For another example, the plurality of line connection patterns LCP and the plurality of pad connection patterns PCP may include molybdenum (Mo), chromium (Cr), titanium (Ti), nickel (Ni), neodymium (Nd), copper (Cu), and an alloy of silver (Ag) and magnesium (Mg), or an alloy thereof.

A third insulating layer 1515c may be disposed on the plurality of line connection patterns LCP and the plurality of pad connection patterns PCP. The third insulating layer 1515c is disposed in the display area DA, the first non-display area NDA1, and the second non-display area NDA2, and may be disposed in all or part of the bending area BA. In the bending area BA, a part of the third insulating layer 1515c may be removed. The third insulating layer 1515c may include an organic insulating material. For example, the third insulating layer 1515c may include a photo resist, a polyimide (PI), or a photo acryl-based material.

A plurality of banks BNK may be disposed on the third insulating layer 1515c in the display area DA. The plurality of banks BNKs may be arranged to overlap with at least a portion of each of the plurality of sub-pixels SPa, SPb and SPc. For example, the first sub-pixel SPa may include a first light emitting device EDa that emits a first color light, the second sub-pixel SPb may include a second light emitting device EDb that emits a second color light, and the third sub-pixel SPc may include a third light emitting device EDc that emits a third color light.

As an example, one light emitting device ED may be arranged on top of each of the plurality of banks BNKs. As another example, two or more light emitting devices ED may be arranged on top of each of the plurality of banks BNK. The two or more light emitting devices EDs arranged on top of each of the plurality of banks BNK may be light emitting devices of the same type. For example, the light emitting devices of the same type may be light emitting devices that emit the same color light. For example, the two or more light emitting devices ED arranged on top of each of the plurality of banks BNK may include a main light emitting device and a redundancy light emitting device.

In the display area DA, a plurality of row connection electrodes RCE may be arranged on the third insulating layer 1515c. The plurality of row connection electrodes RCE may transfer a low-potential voltage VSS output from the driver DRV to the row line RL.

In the display area DA, a plurality of column lines CL may be arranged on the third insulating layer 1515c. The plurality of column lines CL may be arranged in an area between the plurality of banks BNK. For example, the plurality of column lines CL may be arranged adj acent to one of the plurality of banks BNK.

Each of the plurality of column lines CL may include a wiring portion and a column connection electrode CCE protruding from the wiring portion. The wiring portion and the column connection electrode CCE included in each of the plurality of column lines CL may be formed integrally or may be different metals that are electrically connected.

For example, each of the plurality of column lines CL may include a column connection electrode CCE that is a portion protruding above an adjacent bank BNK among the plurality of banks BNK. The column connection electrode CCE of each of the plurality of column lines CL may be arranged to extend along the side and upper surface of the bank BNK. The column connection electrode CCE may be an electrode electrically connected to each of the plurality of column lines CL or may be a portion protruding from each of the plurality of column lines CL.

The column connection electrode CCE of the column line CL may include one conductive layer or multiple conductive layers. For example, a column connection electrode CCE electrically connected to a column line CL or protruding from the column line CL may include a first conductive layer 1601, a second conductive layer 1602, a third conductive layer 1603, and a fourth conductive layer 1604.

The first conductive layer 1601 may be disposed on a bank BNK. The second conductive layer 1602 may be disposed on the first conductive layer 1601. The third conductive layer 1603 may be disposed on the second conductive layer 1602, and the fourth conductive layer 1604 may be disposed on the third conductive layer 1603. For example, each of the first conductive layer 1601, the second conductive layer 1602, the third conductive layer 1603, and the fourth conductive layer 1604 may include titanium (Ti), molybdenum (Mo), aluminum (Al), or titanium (Ti) and indium tin oxide (ITO).

Among the plurality of conductive layers constituting the column connection electrode CCE, some conductive layers having good reflection efficiency may be configured as an alignment key and/or a reflector for aligning the light emitting devices ED. For example, among the plurality of conductive layers constituting the column connection electrode CCE, the second conductive layer 1602 may include a reflective material. For example, the second conductive layer 1602 may include aluminum (Al). Accordingly, the second conductive layer 1602 may be configured as a reflector. In addition, due to the high reflection efficiency of the second conductive layer 1602, it can be easily identified in the manufacturing process, and thus the position or transfer position of the light emitting device ED can be aligned based on the second conductive layer 1602.

For example, to configure the second conductive layer 1602 as a reflector, the third conductive layer 1603 and the fourth conductive layer 1604 disposed on the second conductive layer 1602 may be partially removed or etched. For example, a portion of the third conductive layer 1603 and the fourth conductive layer 1604 disposed on the bank BNK may be removed or etched to expose the upper surface of the second conductive layer 1602. For example, the openings of the third conductive layer 1603 and the fourth conductive layer 1604 may overlap with a portion of the upper surface of the second conductive layer 1602. For example, in the third conductive layer 1603 and the fourth conductive layer 1604, the central portion and the edge portion where a solder pattern SDP is arranged may remain, and the remaining portions excluding this portion (e.g., the central portion, the edge portion) may be removed. For example, the edge portion of each of the third conductive layer 1603 made of titanium (Ti) and the fourth conductive layer 1604 made of indium tin oxide (ITO) may not be etched. Accordingly, it is possible to prevent or obviate other conductive layers of the column connection electrode CCE of the column line CL from being corroded by the TMAH (Tetra Methyl Ammonium Hydroxide) solution used in the mask process of the column connection electrode CCE.

The first conductive layer 1601 and the third conductive layer 1603 may include titanium (Ti) or molybdenum (Mo). The second conductive layer 1602 may include aluminum (Al). The fourth conductive layer 1604 may include a transparent conductive oxide layer such as indium tin oxide (ITO) or indium zinc oxide (IZO) that has good adhesion to the solder pattern SDP and corrosion resistance and acid resistance. However, the example embodiments of the present disclosure are not limited thereto.

The first conductive layer 1601, the second conductive layer 1602, the third conductive layer 1603, and the fourth conductive layer 1604 may be sequentially deposited and then patterned by performing a photolithography process and an etching process.

Two or more of the column connection electrode CCE, the column line CL, the row connection electrode RCE, and the pad PD may be arranged on the same layer. The column connection electrode CCE, the column line CL, the row connection electrode RCE, and the pad PD may include a single layer or multiple layers of a conductive material. For example, two or more of the column connection electrode CCE, the column line CL, the row connection electrode RCE, and the pad PD may be formed of same materials in a same mask process at the same time. For example, two or more of the column connection electrode CCE, the column line CL, the row connection electrode RCE, and the pad PD may include a multiple layer of indium tin oxide (ITO)/titanium (Ti)/aluminum (Al)/titanium (Ti).

A solder pattern SDP may be disposed on the column connection electrode CCE in each of a plurality of sub-pixels. The solder pattern SDP may bond the light emitting device ED to the column connection electrode CCE. The column connection electrode CCE and the light emitting device ED may be electrically connected through eutectic bonding using the solder pattern SDP. For example, if the solder pattern SDP is composed of indium (In) and the first electrode Ecl of the light emitting device ED is composed of gold (Au), the solder pattern SDP and the first electrode Ecl of the light emitting device ED may be bonded by applying heat and pressure in a transfer process of the light emitting device ED. Through eutectic bonding, the light emitting device ED may be bonded to the solder pattern SDP and the column connection electrode CCE without a separate adhesive. For example, the solder pattern SDP may include indium (In), tin (Sn), or an alloy thereof. For example, the solder pattern SDP may be a bonding pad.

The passivation layer 1516 may be disposed on a plurality of column lines CL, a plurality of column connection electrodes CCE, a plurality of row connection electrodes RCE, and a third insulating layer 1515c.

For example, the passivation layer 1516 may be disposed on a display area DA, a first non-display area NDA1, and a second non-display areaNDA2. In the entirety or a portion of the bending area BA, at least a portion of the passivation layer 1516 covering the plurality of pads PD may be removed. A portion of the passivation layer 1516 covering the plurality of pads PD in the second non-display area NDA2 may be removed. In addition, as illustrated in FIG. 11, the passivation layer 1516 may be removed from the area where the solder pattern SDP is arranged.

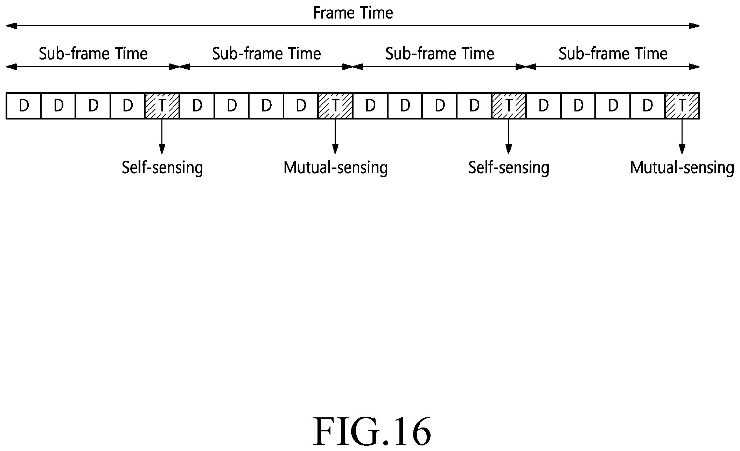

Since the passivation layer 1516 is arranged to cover the remaining area except for the bending area BA, the plurality of pads PD, and the area where the solder pattern SDP is arranged, the penetration of moisture or impurities into the light emitting device ED can be reduced. For example, the passivation layer 1516 may include a single layer or multiple layers of silicon oxide (SiOx) or silicon nitride (SiNx), but the embodiments of the present disclosure are not limited thereto. For example, the passivation layer 1516 may be a protection layer or an insulating layer, but the embodiments of the present disclosure are not limited thereto. For example, as illustrated in FIG. 16, the passivation layer 1516 may include a hole through which the solder pattern SDP is exposed. For example, the hole of the passivation layer 1516 may overlap with the solder pattern SDP.

The light emitting device ED may be arranged on the solder pattern SDP in each of a plurality of sub-pixels SP. The light emitting device ED may be formed on a silicon wafer by a method such as Metal Organic Chemical Vapor Deposition (MOCVD), Chemical Vapor Deposition (CVD), Plasma-Enhanced Chemical Vapor Deposition (PDCVD), Molecular Beam Epitaxy (MBE), Hydride Vapor Phase Epitaxy (HVPD), or Sputtering.

The light emitting device ED may include a first electrode Ecl, a first semiconductor layer 1611, an active layer 1612, a second semiconductor layer 1613, a second electrode Erl, and an encapsulation film 1614. In some cases, the encapsulation film 1614 may not be included in the light emitting device ED.

The first semiconductor layer 1611 may be disposed on the solder pattern SDP. The second semiconductor layer 1613 may be disposed on the first semiconductor layer 1611.

For example, one of the first semiconductor layer 1611 and the second semiconductor layer 1613 may be implemented as a compound semiconductor of group III-V, group II-VI, and may be doped with an impurity (or dopant). For example, one of the first semiconductor layer 1611 and the second semiconductor layer 1613 may be a semiconductor layer doped with an n-type impurity, and the other may be a semiconductor layer doped with a p-type impurity. For example, at least one of the first semiconductor layer 1611 and the second semiconductor layer 1613 may be a layer doped with an n-type or p-type impurity in a material such as gallium nitride (GaN), gallium phosphide (GaP), gallium arsenide phosphide (GaAsP), aluminum gallium indium phosphide (AlGaInP), indium aluminum phosphide (InAlP), aluminum gallium nitride (AlGaN), aluminum indium nitride (AlInN), aluminum indium gallium nitride (AlInGaN), aluminum gallium arsenide (AlGaAs), or gallium arsenide (GaAs), but the embodiments of the present disclosure are not limited thereto. For example, the n-type impurity may be silicon (Si), germanium (Ge), selenium (Se), carbon (C), tellurium (Te), or tin (Sn), but the embodiments of the present disclosure are not limited thereto. For example, the p-type impurity may be magnesium (Mg), zinc (Zn), calcium (Ca), strontium (Sr), barium (Ba), or beryllium (Be).

For example, the first semiconductor layer 1611 and the second semiconductor layer 1613 may be a nitride semiconductor including an n-type impurity and a nitride semiconductor including a p-type impurity, respectively. For example, the first semiconductor layer 1611 may be a nitride semiconductor containing a p-type impurity, and the second semiconductor layer 1613 may be a nitride semiconductor containing an n-type impurity.

The active layer 1612 may be arranged between the first semiconductor layer 1611 and the second semiconductor layer 1613. The active layer 1612 may receive holes and electrons from the first semiconductor layer 1611 and the second semiconductor layer1613) to emit light. For example, the active layer 1612 may be configured as one of a single well structure, a multi-well structure, a single quantum well structure, a multi-quantum well (MQW) structure, a quantum dot structure, and a quantum wire structure. For example, the active layer 1612 may be configured as indium gallium nitride (InGaN) or gallium nitride (GaN). For another example, the active layer 1612 may include a multi-quantum well (MQW) structure having a well layer and a barrier layer having a higher band gap than the well layer. For example, the active layer 1612 may be formed of InGaN as a well layer and an AlGaN layer as a barrier layer.

The first electrode Ecl of the light emitting device ED may be arranged between the first semiconductor layer 1611 and the solder pattern SDP. For example, the first electrode Ecl of the light emitting device ED may electrically connect the first semiconductor layer 1611 and the column connection electrode CCE. The column line voltage (e.g., the anode voltage) output from the driver DRV may be applied to the first semiconductor layer 1611 through the column line CL, the column connection electrode CCE, and the first electrode Ecl. For example, the first electrode Ecl may include a conductive material capable of eutectic bonding with the solder pattern SDP. For example, the first electrode Ecl of the light emitting device ED may include gold (Au), tin (Sn), tungsten (W), silicon (Si), silver (Ag), titanium (Ti), iridium (Ir), chromium (Cr), indium (In), zinc (Zn), lead (Pb), nickel (Ni), platinum (Pt), and copper (Cu), or an alloy thereof.

The second electrode Erl of the light emitting device ED may be disposed on the second semiconductor layer 1613. For example, the second electrode Erl of the light emitting device ED may electrically connect the second semiconductor layer 1613 and the row line RL. A row line voltage (e.g., referred to as a low-potential voltage VSS as a cathode voltage) output from the driver DRV may be applied to the second semiconductor layer 1613 through the row connection electrode RCE, the row line RL, and the second electrode Erl. The second electrode Erl of the light emitting device ED may be made of a transparent conductive material so that light emitted from the light emitting device ED can be directed to the upper portion of the light emitting device ED, but the embodiments of the present disclosure are not limited thereto. For example, the second electrode Erl may be made of a material such as indium tin oxide (ITO), indium zinc oxide (IZO), or indium gallium zinc oxide (IGZO).

The encapsulation film 1614 may be disposed on at least a portion of the first semiconductor layer 1611, the active layer 1612, the second semiconductor layer 1613, the first electrode Ecl, and the second electrode Erl. For example, the encapsulation film 1614 may surround at least a portion of the first semiconductor layer 1611, the active layer 1612, the second semiconductor layer 1613, the first electrode Ecl, and the second electrode Erl.

For example, the encapsulation film 1614 may protect the first semiconductor layer 1611, the active layer 1612, and the second semiconductor layer 1613. For example, the encapsulation film 1614 may be disposed on a side surface of the first semiconductor layer 1611, a side surface of the active layer 1612, and a side surface of the second semiconductor layer 161.

For example, the encapsulation film 1614 may be disposed on at least a portion of the first electrode Ecl and the second electrode Erl of the light emitting device ED. For example, the encapsulation film 1614 may be disposed on an edge portion (or one side) of the first electrode Ecl of the light emitting device ED and an edge portion (or one side) of the second electrode Erl of the light emitting device ED. At least a portion of the first electrode Ecl may be exposed from the encapsulation film 1614 so that the first electrode Ecl may be connected to the solder pattern SDP. For example, at least a portion of the second electrode Erl may be exposed from the encapsulation film 1614 so that the second electrode Erl may be connected to the row line RL. For example, the encapsulation film 1614 may be made of an insulating material such as silicon nitride (SiNx) or silicon oxide (SiOx).

For another example, the encapsulation film 1614 may have a structure in which a reflective material is dispersed in a resin layer, but the embodiments of the present disclosure are not limited thereto. For example, the encapsulation film 1614 may be manufactured as a reflector of various structures, but the embodiments of the present disclosure are not limited thereto. Light emitted from the active layer 1612 may be reflected upward by the encapsulation film 1614, thereby improving light extraction efficiency. For example, the encapsulation film 1614 may be a reflective layer.

The light emitting device ED may have a vertical structure. Alternatively, the light emitting device ED may have a lateral structure or a flip chip structure.

The structure of the light emitting device ED illustrated in FIG. 11 may be substantially equally applied to all of the first light emitting device EDa, the second light emitting device EDb, and the third light emitting device EDc. A first optical layer 1517a may be arranged to surround a plurality of light emitting devices ED in the display area DA. For example, the first optical layer 1517a may be arranged to cover a plurality of light emitting devices ED and the bank BNK in the area of a plurality of sub-pixels SP. For example, the first optical layer 1517a may cover a bank BNK, a portion of the passivation layer 1516, and a region between the plurality of light emitting devices ED. The first optical layer 1517a may be arranged or covered between a plurality of light emitting devices ED included in one pixel and between a plurality of banks BNK. For example, the first optical layer 1517a may be arranged to surround the side of the light emitting devices ED and the banks BNK between the passivation layer 1516 and the row line RL. For example, the first optical layer 1517a may be a diffusion layer or a sidewall diffusion layer.

The first optical layer 1517a may include an organic insulating material having fine particles dispersed therein. For example, the first optical layer 1517a may include siloxane having fine metal particles, such as titanium dioxide (TiO2) particles, dispersed therein. Light from a plurality of light emitting devices ED may be scattered by the fine particles dispersed in the first optical layer 1517a and emitted to the outside of the display device 100. Accordingly, the first optical layer 1517a may improve the extraction efficiency of light emitted from the plurality of light emitting devices ED.

For example, the first optical layer 1517a may be arranged on each of a plurality of pixels, or may be arranged together on some pixels arranged in the same row. For example, the first optical layer 1517a may be arranged on each of a plurality of pixels, or the plurality of pixels may share one first optical layer 1517a. For another example, each of the plurality of sub-pixels may separately include a first optical layer 1517a.

In the display area DA, a second optical layer 1517b may be arranged on the passivation layer 1516. For example, the second optical layer 1517b may be arranged to surround the first optical layer 1517a. For example, the second optical layer 1517b may be in contact with a side surface of the first optical layer 1517a. For example, the second optical layer 1517b may be arranged in an area between the plurality of pixels. For example, the second optical layer 1517b may be a diffusion layer, a diffusion layer window, or a window diffusion layer.

The second optical layer 1517b may include an organic insulating material. The second optical layer 1517b may include the same material as the first optical layer 1517a. For example, the first optical layer 1517a may include fine particles, and the second optical layer 1517b may not include fine particles. For example, the second optical layer 1517b may include siloxane.

For example, the thickness of the first optical layer 1517a may be smaller than the thickness of the second optical layer 1517b. Accordingly, when viewed from a planar view, the area where the first optical layer 1517a is disposed may include a concave portion that is sunken inwardly from the upper surface of the second optical layer 1517b.

The row line RL may be disposed on the first optical layer 1517a and the second optical layer 1517b. For example, the row line RL may be electrically connected to a plurality of row connection electrodes RCE through contact holes of the second optical layer 1517b. For example, the row line RL may be disposed on a plurality of light emitting devices ED. For example, the row line RL may include a transparent conductive oxide such as indium tin oxide (ITO) or indium zinc oxide (IZO). For example, the row line RL may be arranged to be in contact with the second electrode Erl of the light emitting device ED. For example, the row line RL may overlap with the first optical layer 1517a. For example, the row line RL may cover a plane on the outside of the first optical layer 1517a.

The row line RL may extend continuously in the first direction (X) of the substrate 210. Accordingly, the row line RL may be commonly connected to a plurality of pixels arranged in the first direction (X) of the substrate 210. For example, the row line RL may be commonly connected to a plurality of pixels.

The row line RL may be continuously extended on the first optical layer 1517a, the second optical layer 1517b, and the light emitting device ED. The area where the first optical layer 1517a is disposed may include a concave portion that is sunken inwardly from the upper surface of the second optical layer 1517b. Accordingly, the first part of the row line RL disposed on the first optical layer 1517a may be disposed along the concave portion, and thus may be disposed at a lower position than the second part of the row line RL disposed on the second optical layer 1517b.

A third optical layer 1517c may be disposed on the row line RL. The third optical layer 1517c may be disposed so as to overlap with a plurality of light emitting devices ED and the first optical layer 1517a. Since the third optical layer 1517c is arranged on the row line RL and the plurality of light emitting devices ED, it is possible to improve a mura that may occur in some of the plurality of light emitting devices ED. For example, when transferring a plurality of light emitting devices ED onto the substrate 210 of the display panel 110, there may occur an area where the spacing between the plurality of light emitting devices ED is not uniform due to process deviation. If the spacing between the plurality of light emitting devices ED is not uniform, an emission area of each of the plurality of light emitting devices ED may be arranged unevenly, and thus a mura may be visible to the user. Accordingly, since the third optical layer 1517c is arranged to uniformly diffuse light over the plurality of light emitting devices ED, it is possible to reduce light emitted from some of the light emitting devices ED from being visible as a mura. Accordingly, since the light emitted from the plurality of light emitting devices EDs is evenly diffused by the third optical layer 1517c and extracted to the outside of the display device 100, the luminance uniformity of the display device 100 can be improved.

The third optical layer 1517c may include an organic insulating material in which fine particles are dispersed. For example, the third optical layer 1517c may include siloxane in which fine metal particles such as titanium dioxide (TiO2) particles are dispersed. For example, the third optical layer 1517c may include the same material as the first optical layer 1517a. For example, the third optical layer 1517c may be a diffusion layer or an upper diffusion layer.

Light from a plurality of light emitting devices ED may be scattered by fine particles dispersed in a third optical layer 1517c and emitted to the outside of the display device 100. The third optical layer 1517c may evenly mix light emitted from a plurality of light emitting devices ED, thereby further improving the luminance uniformity of the display device 100. In addition, the light extraction efficiency of the display device 100 may be improved by the light scattered from the plurality of fine particles, thereby enabling the display device 100 to be driven at low power.

A black matrix BM may be arranged on the row line RL, the first optical layer 1517a, the second optical layer 1517b, and the third optical layer 1517c in the display area DA. For example, the black matrix BM may fill a contact hole of the second optical layer 1517b. The black matrix BM may be configured to cover the display area DA, so that the color mixing of light and external light reflection of the plurality of sub-pixels can be reduced. For example, the black matrix BM may also be arranged in the contact hole where the row line RL and the row connection electrode RCE are connected, so that light leakage between the neighboring plurality of sub-pixels can be prevented or reduced. For example, the black matrix BM may include an opaque material. For example, the black matrix BM may be an organic insulating material to which a black pigment or a black dye is added.

A cover layer 1518 may be arranged on the black matrix BM in the display area DA. The cover layer 1518 may protect a configuration under the cover layer 1518. For example, the cover layer 1518 may include an organic insulating material. For example, the cover layer 1518 may include a photo resist, polyimide (PI), or photo acryl-based material. For example, the cover layer 1518 may be an overcoating layer or an insulating layer.

A polarizing layer 114 may be arranged on the cover layer 1518 via a first adhesive layer 112. A cover member 118 may be arranged on the polarizing layer 114 via a second adhesive layer 116. For example, the first adhesive layer 112 and the second adhesive layer 116 may include an optically clear adhesive (OCA), an optically clear resin (OCR), or a pressure sensitive adhesive (PSA).

A plurality of pads PD may be arranged on a third insulating layer 1515c in a second non-display area NDA2. For example, at least a portion of the plurality of pads PD may be exposed from a passivation layer 1516. For example, the plurality of pads PD may be electrically connected to a fourth pad connection pattern PCP4 through a contact hole of the third insulating layer 1515c.

An adhesive layer ACF may be arranged on the plurality of pads PD. The adhesive layer ACF may be an adhesive layer in which conductive balls are dispersed in an insulating material. The adhesive layer ACF may be disposed between a plurality of pads PD and a flexible printed circuit 102, so that the flexible printed circuit 102 may be attached or bonded to the plurality of pads PD. For example, the adhesive layer ACF may be an anisotropic conductive film ACF.

A flexible printed circuit 102 may be disposed on the adhesive layer ACF. The flexible printed circuit 102 may be electrically connected to the plurality of pads PD through the adhesive layer ACF. Accordingly, a signal supplied from the flexible printed circuit 102 may be transmitted to a driver DRV of a display area DA through the plurality of pads PD, the fourth pad connection pattern PCP4, the third pad connection pattern PCP3, the second pad connection pattern PCP2, and the first pad connection pattern PCP1.

The display panel 110 according to the embodiments of the present disclosure may include a substrate 210, a layer stack 1410 on a plurality of drivers DRV disposed on the substrate 210, an optical layer 1517a disposed between a plurality of light emitting devices EDa, EDb and EDc on the layer stack 1410, an adhesive layer 116 disposed on the plurality of light emitting devices EDa, EDb and EDc and the optical layer 1517a, and a cover member 118 disposed on the adhesive layer 116.

A plurality of column lines CL may be disposed between the layer stack 1410 and the plurality of light emitting devices EDa, EDb and EDc. A plurality of row lines RL may be arranged on a plurality of light emitting devices EDa, EDb and EDc and an optical layer 1517a. A plurality of row lines RL may be arranged between a plurality of light emitting devices EDa, EDb and EDc, an optical layer 1517a, and an adhesive layer 116.

A layer stack 1410 may include a plurality of protection layers 1513a, 1513b and 1514 arranged on the side and upper surface of each of a plurality of drivers DRV, a plurality of insulating layers 1515a, 1515b and 1515c arranged on the plurality of protection layers 1513a, 1513b and 1514, and a bank BN arranged on the plurality of insulating layers.

The plurality of protection layers 1513a, 1513b and 1514 may further include a side protection layer 1513 disposed on each side of the plurality of drivers DRV and an upper protection layer 1514 disposed on the upper surface of each of the plurality of drivers DR.

The side protection layer 1513 may include a first protection layer 1513a disposed on the substrate 210 and a second protection layer 1513b disposed on the first protection layer 1513a. The upper protection layer 1514 may include a second protection layer 1513b and a third protection layer 1514 disposed on the plurality of drivers DRV.

The plurality of insulating layers 1515a, 1515b and 1515c may include a first insulating layer 1515a disposed on the upper protection layer 1514, and a second insulating layer 1515b disposed on the first insulating layer 1515a. The plurality of insulating layers 1515a, 1515b and 1515c may further include a third insulating layer 1515c disposed on the second insulating layer1515b.

Each of the plurality of light emitting devices EDa, EDb and EDc may be disposed on the bank BNK and positioned in an opening of the optical layer 1517a.

At least a portion of each of the plurality of column lines CL may extend onto the bank BNK on the plurality of insulating layers 1515a, 1515b and 1515c. Each of the plurality of row lines RL may be arranged on the optical layer 1517a and the plurality of light emitting devices EDa, EDb and EDc.

A first electrode Ecl of each of the plurality of light emitting devices EDa, EDb and EDc may be electrically connected to at least a portion of a column line CL extending onto the bank BNK among the plurality of column lines CL. A second electrode Erl of each of the plurality of light emitting devices EDa, EDb and EDc may be electrically connected to one of the plurality of row lines RL.

The display panel 110 may include a plurality of line connection patterns LCPs that connect each of a plurality of lines including a plurality of row lines RL and a plurality of column lines CL to a plurality of drivers DR.

The plurality of line connection patterns LCPs may include a first line connection pattern LCP1 disposed on a side protection layer 1513, a second line connection pattern LCP2 disposed on an upper protection layer 1514 and electrically connected to the first line connection pattern LCP1 through a hole in the upper protection layer 1514, a third line connection pattern LCP3 disposed on a first insulating layer 1515a and electrically connected to the second line connection pattern LCP2 through a hole in the first insulating layer 1515a, and a fourth line connection pattern LCP4 disposed on a second insulating layer 1515b and electrically connected to the third line connection pattern LCP3 through a hole in the second insulating layer 1515b.

The first line connection pattern LCP1 may be electrically connected to one of the plurality of drivers DRV. The fourth line connection pattern LCP4 may be electrically connected to at least one second electrode Erl of the plurality of light emitting devices EDa, EDb and EDc, or may be electrically connected to at least one first electrode Ecl of the plurality of light emitting devices EDa, EDb and EDc.

The side protection layer 1513 arranged on each side of the plurality of drivers DRV may include two or more organic layers.

The first and second protection layers 1513a and 1513b as the side protection layer 1513, the third protection layer 1514 as the upper protection layer 1514, and the first to third insulating layers 1515a, 1515b and 1515c may each include organic layers.

In the above, there have been described the structure and operation related to the display function of the display device 100 according to the embodiments of the present disclosure. The display device 100 according to the embodiments of the present disclosure may provide not only a display function but also a touch sensing function. Accordingly, hereinafter, it will be described a structure and an operation related to the touch sensing function of the display device 100 according to the embodiments of the present disclosure.

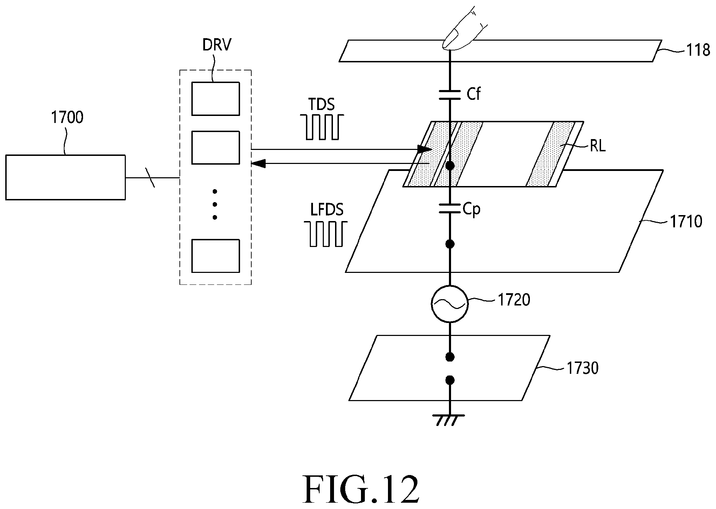

FIG. 12 is a diagram briefly illustrating the touch sensing structure of the display device 100 according to the embodiments of the present disclosure.

Referring to FIG. 12, the display device 100 according to the embodiments of the present disclosure may include a plurality of row lines RL that serve as touch sensors or touch electrodes to perform touch sensing, a plurality of drivers DRV for driving and sensing the plurality of row lines RL, and a touch control circuit 1700 that controls the plurality of drivers DRV.

The plurality of drivers DRV may supply a touch driving signal TDS having a variable voltage level to at least one of the plurality of row lines RL.

The touch driving signal TDS is a signal whose voltage level fluctuates, and may also be referred to as an AC signal or a pulse signal. For example, the touch driving signal TDS may have a signal waveform such as a square wave, a sine wave, or a triangular wave. For example, the frequency of the touch driving signal TDS may be constant. For another example, the frequency of the touch driving signal TDS may be variable. If the frequency of the touch driving signal TDS is variable according to the touch driving period T or time, it is possible to prevent or reduce the touch sensitivity degradation due to noise generated during the touch driving.

A plurality of drivers DRV may sense or detect an electrical state (e.g., a capacitance change) in at least one of a plurality of row lines RL to generate sensing data, and output the generated sensing data. Here, the sensing data may include digital sensing values.

The plurality of drivers DRV may include at least one analog-to-digital converter ADC to sense an electrical state in at least one of the plurality of row lines RL to obtain digital sensing values. However, the present disclosure is not limited thereto. For example, the plurality of drivers DRV may provide the sensing value in analog form to the touch control circuit 1700 where the analog-to-digital conversion is performed.

For example, the electrical state in at least one of the plurality of row lines RL may include a capacitance Cf between a touch object such as a finger or a pen and each row line RL. For another example, the electrical state in at least one of the plurality of row lines RL may include a capacitance between two row lines RL.

The touch control circuit 1700 may supply a touch driving signal TDS or a signal as a base of the touch driving signal TDS to each of the plurality of drivers DRV, and determine an occurrence of a touch or a touch position based on sensing data provided from each of the plurality of drivers RV. For example, the touch control circuit 1700 may include a timing controller or a micro-control unit. The touch control circuit 1700 may further include a power management integrated circuit PMIC, etc.

If a touch driving signal TDS is applied to at least one of a plurality of row lines RL for touch sensing, an unwanted parasitic capacitance Cp may be formed between the row line RL supplied with the touch driving signal TDS and other electrodes or other wirings around the corresponding row line RL. The parasitic capacitance Cp may be a factor causing a reduction of the touch sensitivity.

The display device 100 may further include a touch ground 1710 arranged below the plurality of row lines RL. The touch ground 1710 may correspond to an electrode that forms a parasitic capacitance Cp with the row line RL.

The display device 100 according to the embodiments of the present disclosure may further include a guard driver 1720 that supplies a load-free driving signal LFDS whose signal characteristics correspond to the touch driving signal TDS to the touch ground 1710 so as to prevent or reduce an unwanted parasitic capacitance Cp from being formed between the row line RL and the touch ground 1710.

The load-free driving signal LFDS output from the guard driver 1720 applied to the touch ground 1710 may be a signal whose signal characteristics are similar to the touch driving signal TDS output from the driver DRV and supplied to the row line RL. For example, the signal characteristics may include frequency, amplitude, and phase. For example, the load-free driving signal LFDS may have the same frequency as the touch driving signal TDS. The load-free driving signal LFDS may have the same amplitude as the touch driving signal TDS. The load-free driving signal LFDS may have the same phase as the touch driving signal TDS.

The display device 100 according to the embodiments of the present disclosure may further include a system ground 1730 that serves as a ground for the entire system.

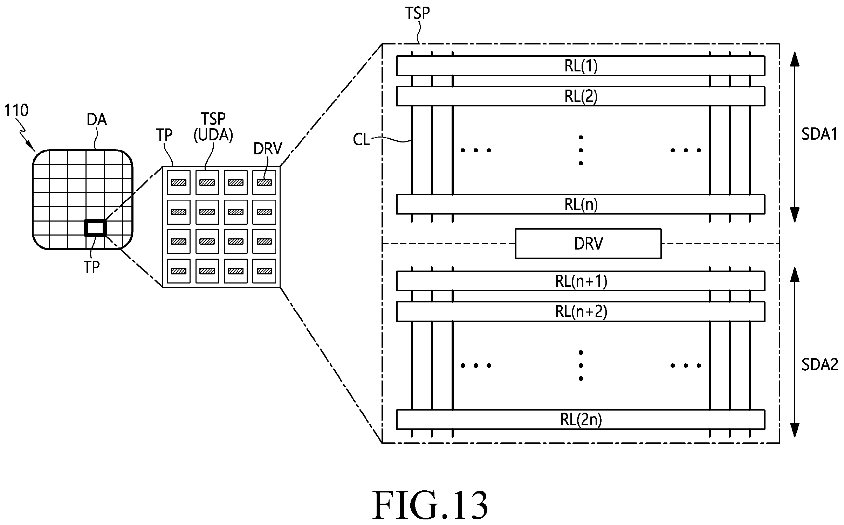

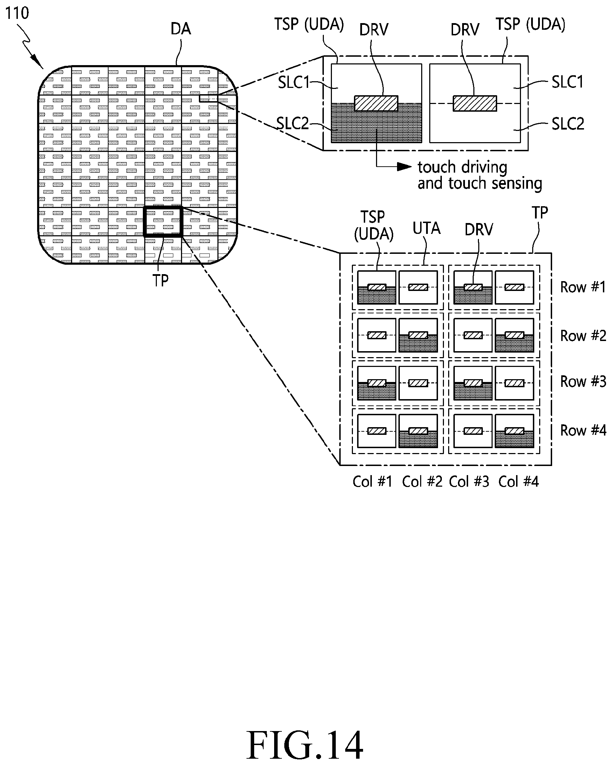

FIG. 13 and 14 illustrate a touch driving structure of a display panel 110 according to embodiments of the present disclosure. FIGS. 1 to 12 are also referred to in the following description.

Referring to FIGS. 13 and 14, the display area DA of the display panel 110 may include a plurality of touch pixel areas TP. Each of the plurality of touch pixel areas TP may be an area corresponding to one touch electrode TE.

Each of the plurality of touch pixel areas TP may include a plurality of touch sub-pixel areas TSP. According to the examples of FIGS. 13 and 14, each of the plurality of touch pixel areas TP may include 16 touch sub-pixel areas TSP. The 16 touch sub-pixel areas TSP may be arranged in four rows and four columns.

Each of the plurality of touch sub-pixel areas TSP may include one or more of the plurality of drivers DRV. For example, one driver DRV may be disposed in one touch sub-pixel area TSP. One touch sub-pixel area TSP may correspond to one unit driving area UDA.

Each of the plurality of touch sub-pixel areas TSP may include a plurality of row lines RL(1) to RL(2n), (where n is a natural number greater than or equal to 1) and a plurality of column lines CL. Each of the plurality of touch sub-pixel areas TSP may include a plurality of sub-pixels SP. Each of the plurality of touch sub-pixel areas TSP may include a plurality of light emitting devices ED.

Each of the plurality of touch sub-pixel areas TSP may include a first sub-driving area SDA1 and a second sub-driving area SDA2. The first sub-driving area SDA1 may include two or more row lines RL(1) to RL(n) and two or more column lines CL. The second sub-driving area SDA2 may include two or more row lines RL(n+1) to RL(2n) and two or more column lines CL.

A plurality of row lines RL arranged in one touch pixel area TP corresponding to one touch electrode and simultaneously performing touch driving may be processed as one touch electrode TE in the touch control circuit 1700 even if they are driven and sensed by a plurality of drivers DRV. For example, a plurality of row lines RL arranged in one touch pixel area TP and simultaneously performing touch driving may be recognized as one touch electrode TE electrically connected to each other.

The touch control circuit 1700 may determine an occurrence of the touch and/or a touch coordinate by considering the integrated sensing data SEN_DATA obtained from each of the plurality of row lines RL arranged in one touch pixel area TP and simultaneously performing touch driving as sensing data obtained from one touch electrode TE.

Referring to FIG. 14, each of the plurality of touch pixel areas TP may include two or more unit touch driving areas UTA. Each of the two or more unit touch driving areas UTA may include at least one touch sub-pixel area TSP. According to the example of FIG. 14, each of the two or more unit touch driving areas UTA may include two touch sub-pixel areas TSP. Here, the unit touch driving area UTA is an area that becomes a basic unit of a touch driving pattern.

One touch sub-pixel area TSP corresponding to one unit driving area UDA may include two sub-touch driving areas SLC1 and SLC2. The two sub-touch driving areas may include a first sub-touch driving area SLC1 and a second sub-touch driving area SLC2. For example, the first sub-touch driving area SLC1 may correspond to an upper area in one touch sub-pixel area TSP, and the second sub-touch driving area SLC2 may correspond to a lower area in one touch sub-pixel area TSP. However, embodiments of the present disclosure are not limited thereto.

Two or more row lines RL and two or more column lines CL may be arranged in each of the first sub-touch driving area SLC1 and the second sub-touch driving area SLC2. Each of the first sub-touch driving area SLC1 and the second sub-touch driving area SLC2 may include two or more light emitting devices ED.

Two or more row lines RL arranged in the first sub-touch driving area SLC1 and two or more row lines RL arranged in the second sub-touch driving area SLC2 may not be connected to each other, and may be arranged separately from each other. Two or more column lines CL arranged in the first sub-touch driving area SLC1 and two or more column lines CL arranged in the second sub-touch driving area SLC2 may not be connected to each other, and may be arranged separately from each other.

The two sub-touch driving areas SLC1 and SLC2 may correspond to the two sub-driving areas SDA1 and SDA2 included in one unit driving area UDA.

One unit touch driving area UTA may include two touch sub-pixel areas TSP. One unit touch driving area UTA may include two sub-touch driving areas SLC1 and SLC2 included in each of two touch sub-pixel areas TSP. For example, one unit touch driving area UTA may include four sub-touch driving areas. One unit touch driving area UTA may include two drivers DRV.

For example, a touch pixel area TP may include 16 touch sub-pixel areas TSP arranged in four rows and four columns. Each of the 16 touch sub-pixel areas TSP may include one driver DRV and two sub-touch driving areas SLC1 and SLC2.

As an example, during a touch driving period for touch sensing, all four sub-touch driving areas included in one unit touch driving area UTA may be driven and sensed. Accordingly, during a touch driving period for touch sensing, each of the two drivers DRV included in one unit touch driving area UTA may drive and sense all two sub-touch driving areas SLC1 and SLC2 included in the corresponding touch sub-pixel area TSP.

As another example, during a touch driving period for touch sensing, only some of the four sub-touch driving areas included in one unit touch driving area UTA may be driven and sensed. According to the example of FIG. 14, during the touch driving period for touch sensing, one sub-touch driving area among four sub-touch driving areas included in one unit touch driving area UTA may be driven and sensed. Accordingly, during the touch driving period for touch sensing, one driver DRV among two drivers DRV included in one unit touch driving area UTA may drive and sense one of two sub-touch driving areas SLC1 and SLC2 included in the corresponding touch sub-pixel area TSP.

According to the embodiments of the present disclosure, the fact that the sub-touch driving area is driven and sensed may mean that two or more row lines RL arranged in the sub-touch driving area are driven (e.g., touch driven) and sensed.

The fact that two or more row lines RL arranged in the sub-touch driving area are driven (e.g., touch driven) may mean that a touch driving signal TDS having a variable voltage level is applied to two or more row lines RL arranged in the sub-touch driving area.

Referring to FIG. 14, in the touch pixel area TP, the sub-touch driving area where touch driving and touch sensing are performed may be arranged in a zigzag shape.

For example, if a touch pixel area TP includes 16 touch sub-pixel areas TSP arranged in four rows and four columns, in each of the first touch sub-pixel row Row #1 and the third touch sub-pixel row Row #3, the second sub-touch driving area SLC2 among the two sub-touch driving areas SLC1 and SLC2 included in the touch sub-pixel area TSP located in the first column Col #1 may be driven and sensed, the two sub-touch driving areas SLC1 and SLC2 included in the touch sub-pixel area TSP located in the second column Col #2 may be not driven and sensed. In addition, the second sub-touch driving area SLC2 among the two sub-touch driving areas SLC1 and SLC2 included in the touch sub-pixel area TSP located in the third column Col #3 may be driven and sensed, and the two sub-touch driving areas SLC1 and SLC2 included in the touch sub-pixel area TSP located in the fourth column Col #4 may not be driven and sensed.

In the second touch sub-pixel row Row #2 and the fourth touch sub-pixel row Row #4, the two sub-touch driving areas SLC1 and SLC2 included in the touch sub-pixel area TSP located in the first column Col #1 may not be driven and sensed, and the second sub-touch driving area SLC2 among the two sub-touch driving areas SLC1 and SLC2 included in the touch sub-pixel area TSP located in the second column Col #2 may be driven and sensed. In addition, the two sub-touch driving areas SLC1 and SLC2 included in the touch sub-pixel area TSP located in the third column Col #3 may not be driven and sensed, and the second sub-touch driving area SLC2 among the two sub-touch driving areas SLC1 and SLC2 included in the touch sub-pixel area TSP located in the fourth column Col #4 may be driven and sensed. Alternatively, the first sub-touch driving area SLC1 may be driven and sensed instead of the second sub-touch driving area SLC2.

Referring to FIG. 14, one touch pixel area TP includes a plurality of touch sub-pixel areas TSP, and each of the plurality of touch sub-pixel areas TSP may include two or more row lines RL and two or more column lines CL. Each of the plurality of touch sub-pixel areas TSP may include two or more light emitting devices ED.

Referring to FIG. 14, one touch pixel area TP includes a plurality of touch sub-pixel areas TSP, and each of the plurality of touch sub-pixel areas TSP may include two sub-touch driving areas SLC1 and SLC2. Each of the two sub-touch driving areas SLC1 and SLC2 may include two or more row lines RL and two or more column lines CL. Each of the two sub-touch driving areas SLC1 and SLC2 may include two or more light emitting devices ED. As stated above, the row lines RL connected to the second electrodes of the light emitting devices are provided to be acted as the touch electrodes, but the present disclosure is not limited thereto. For example, when the column lines CL instead of the row lines, are connected to the second electrodes of the light emitting devices, the column lines CL may be used as the touch electrodes. Accordingly, the extending direction of the lines (row lines or column lines) used as the touch electrodes is not limited in the present disclosure. In this case, the row lines RL of the present disclosure may be referred as first lines which may extend in a first direction, and the column lines CL may be referred to as second lines which may extend in a second direction intersects with the first direction. Thus, the row connection lines RCL may be referred to as first connection lines.

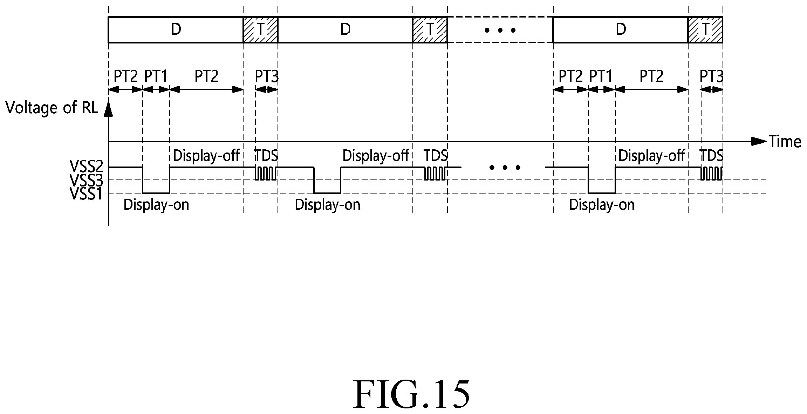

FIG. 15 and FIG. 16 are driving timing diagrams of a display device 100 according to embodiments of the present disclosure.

The display device 100 according to the embodiments of the present disclosure may perform display driving for image display and touch driving (or touch sensing) for touch sensing. The display device 100 according to the embodiments of the present disclosure may allocate a display driving period D and a touch driving period T, perform display driving during the display driving period D, and perform touch driving during the touch driving period T.

The display device 100 according to the embodiments of the present disclosure may perform display driving and touch driving according to a time-division driving method or a simultaneous driving method.

For example, the display device 100 according to the embodiments of the present disclosure may allocate the display driving period D and the touch driving period T as separate time periods according to the time-division driving method, and may perform display driving during the display driving period D and perform touch driving during the touch driving period T different from the display driving period D.

As another example, the display device 100 according to the embodiments of the present disclosure may perform display driving and touch driving simultaneously during the display driving period D and the touch driving period T that overlap in time according to the simultaneous driving method.

Hereinafter, for the convenience of explanation, the display device 100 according to the embodiments of the present disclosure performs display driving and touch driving at different time periods according to the time division driving method as an example. However, this is not limited thereto.

As an example of a time division driving method, as illustrated in FIG. 15, one display driving period D and one touch driving period T may alternately proceed. For example, one display driving period D may proceed, and then one touch driving period T may proceed.

As an example, one display driving period D may be a period during which display driving is performed to display an image on the entire screen. For example, the period that is the sum of one display driving period D and one touch driving period T may be a frame time. In this case, one display driving period D may correspond to an active period among the active time and a blank time included in one frame time, and one touch driving period T may correspond to a blank time among the active time and blank time included in one frame time.

As another example, two or more display driving periods D may be a period during which display driving is performed to display an image on the entire screen. For example, the time period that is the sum of two or more display driving periods D and two or more touch driving periods T may be a frame time. In this case, one frame time may include two or more sub-frame times. Each of the two or more sub-frame times may include a sub-active time and a sub-blank time. The time summing one display driving period D and one touch driving period T may be one sub-frame time among two or more sub-frame times included in one frame time. One display driving period D included in one sub-frame time may correspond to a sub-active time, and one touch driving period T may correspond to a sub-blank time.

As another example of the time division driving method, as illustrated in FIG. 16, a plurality of display driving periods D and one touch driving period T may alternately proceed. For example, a plurality of display driving periods D may proceed, and then one touch driving period T may proceed.

According to the example of FIG. 16, four display driving periods D may be performed, and then one touch driving period T may be performed. For example, the time summing four display driving periods D and one touch driving period T may correspond to one sub-frame time, and the time summing four sub-frame times may correspond to one frame time for displaying an image on the entire screen.

According to the example of FIG. 16, four touch driving periods T included in one frame time may include self-sensing-based touch driving periods T and mutual-sensing-based touch driving periods T that are alternately proceeded. For example, among the four touch driving periods T included in one frame time, the first and third touch driving periods T may be self-sensing-based touch driving periods T, and the second and fourth touch driving periods T may be mutual-sensing-based touch driving periods T.

Self-sensing-based touch driving may be a touch driving for determining an occurrence of a touch and/or a touch coordinate based on a capacitance (e.g., self-capacitance) between a plurality of row lines RL corresponding to a touch electrode TE and a touch object (e.g., a finger, a pen, etc.).

Mutual-sensing-based touch actuation may be a touch driving for determining an occurrence of a touch and/or a touch coordinate based on a capacitance (e.g., mutual-capacitance) between a plurality of row lines RL corresponding to a touch electrode TE and a plurality of row lines RL corresponding to another touch electrode TE.

Referring to FIG. 15, a plurality of row lines RL may simultaneously perform the role of a cathode electrode (or an anode electrode) for display driving and the role of a touch sensor (e.g., touch electrode) for touch driving. Therefore, the electrical state of the row line RL during the display driving period D and the electrical state of the row line RL during the touch driving period T may be different.

One row line RL among the plurality of row lines RL may be supplied with a first low-potential voltage VSS1 during a first period PT1, and may be supplied with a second low-potential voltage VSS2 during a second period PT2 different from the first period PT1.

The first period PT1 and the second period PT2 may be periods included in one display driving period D or periods included in different display driving periods D.

The first low-potential voltage VSS1 and the second low-potential voltage VSS2 are a type of low-potential voltage VSS and may be a row line voltage applied to the row line RL. In addition, the first low-potential voltage VSS1 and the second low-potential voltage VSS2 may be a voltage (for example, a cathode voltage or an anode voltage) applied to the second electrode Erl of the light emitting devices ED connected to the row line RL.

Among the first low-potential voltage VSS1 and the second low-potential voltage VSS2, the first low-potential voltage VSS1 may be a low-potential voltage for driving the display-on, and the second low-potential voltage VSS2 may be a low-potential voltage for driving the display-off.

The first low-potential voltage VSS1 may be a voltage lower than the second low-potential voltage VSS2. For example, the second low-potential voltage VSS2 may be a higher voltage than the first low-potential voltage VSS1. Accordingly, during the first period PT1, the voltage difference between the first electrode Ecl and the second electrode Erl of the light emitting device ED may be higher than the threshold voltage of the light emitting device ED. Accordingly, the light emitting device ED may be in a state capable of emitting light. Then, during the second period PT2, the voltage difference between the first electrode Ecl and the second electrode Erl of the light emitting device ED may be lower than the threshold voltage of the light emitting device ED. Accordingly, the light emitting device ED may be in a state in which it cannot emit light.

In addition, one of the plurality of row lines RL may be supplied with a touch driving signal TDS, which is a signal whose voltage level swings, during a third period PT3 different from the first period PT1 and the second period PT2.

The third period PT3 may be a period included in the touch driving period T. The touch driving signal TDS may be a signal having a predetermined frequency and whose voltage level fluctuates. The touch driving signal TDS may be a signal that swings between a predefined high voltage and a low voltage. For example, the high voltage may be a second low-potential voltage VSS2, and the low voltage may be a third low-potential voltage VSS3. The amplitude of the touch driving signal TDS may be a voltage difference between the high voltage and the low voltage. For example, the third low-potential voltage VSS3 may be a voltage lower than the second low-potential voltage VSS2 and may be the same as or different from the first low-potential voltage VSS1. For example, the third low-potential voltage VSS3 may be a voltage higher than the first low-potential voltage VSS1 and lower than the second low-potential voltage VSS2.

Depending on the driving type and driving timing, each of the plurality of row lines RL may be driven in a predetermined method.

For example, the display-on driving for each of the plurality of row lines RL may be performed sequentially. For another example, the display-on driving for each of the plurality of row lines RL may be performed simultaneously. For another example, the display-on driving for each of two or more row lines RL among the plurality of row lines RL may be performed simultaneously.

For example, during a specific display driving period, among the plurality of row lines RL arranged in the unit driving area UDA, display-on driving may be performed for at least one row line RL, and display-off driving may be performed for the remaining row lines RL without display-on driving.

The display-on driving performed for a specific row line RL may mean that a first low-potential voltage VSS1 of a predefined level is supplied to the corresponding row line RL.

When the display-on driving for a specific row line RL is performed, the light emitting devices ED arranged corresponding to the corresponding row line RL may emit light.

The display-off driving performed for a specific row line RL without display-on driving may mean that a second low-potential voltage VSS2 of a predefined level is supplied to the corresponding row line RL. Here, the second low-potential voltage VSS2 may be a higher voltage than the first low-potential voltage VSS1.

When display-off driving is performed for a specific row line RL, the light emitting devices ED arranged corresponding to the row line RL may not emit light.

For example, a first row line RL among the plurality of row lines RL may be supplied with a first low-potential voltage VSS1 during a first period, and may be supplied with a second low-potential voltage VSS2 higher than the first low-potential voltage VSS1 during a second period different from the first period. For example, the first period and the second period may be included in one display driving period. For another example, the first period and the second period may be included in different display driving periods.

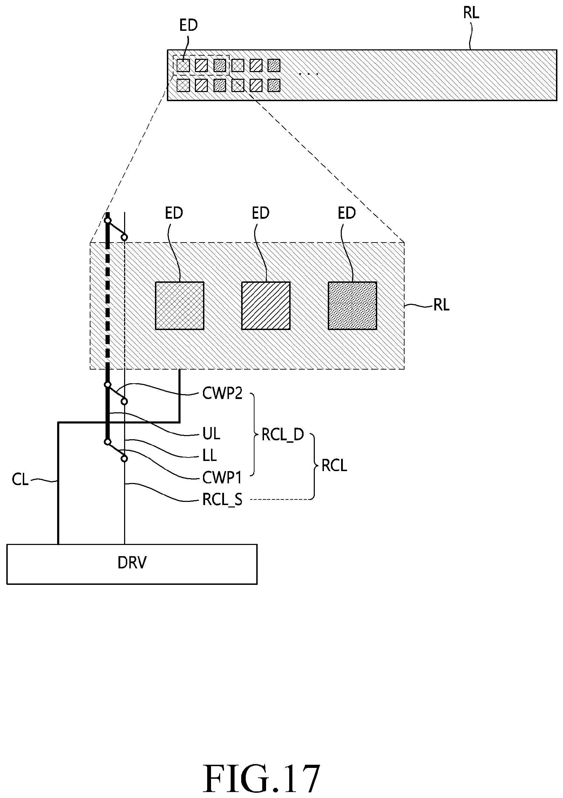

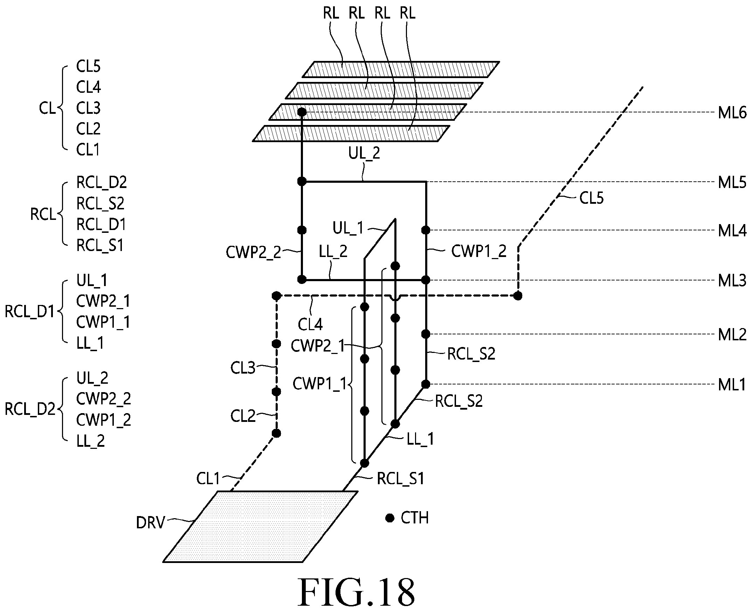

FIGS. 17 and 18 illustrate a connection structure between a row line RL and a driver DRV in a display panel according to embodiments of the present disclosure. However, FIGS. 1 to 16 are also referred to in the following description.

A display panel 110 according to embodiments of the present disclosure may include a substrate 210, a plurality of light emitting devices ED disposed on the substrate 210 and positioned in a display area DA, a plurality of column lines CL electrically connected to a first electrode of each of the plurality of light emitting devices ED, a plurality of row lines RL electrically connected to a second electrode of each of the plurality of light emitting devices ED, a plurality of drivers DRV for driving the plurality of column lines CL and the plurality of row lines RL, and a plurality of row connection lines RCL electrically connecting the plurality of row lines RL to the plurality of drivers DRV.

According to embodiments of the present disclosure, the plurality of drivers DRV and the plurality of row connection lines RCL may be disposed in a display area DA of the display panel 110.

Referring to FIG. 17, at least one of the plurality of row connection lines RCL may include a multi-wiring section RCL_D. The multi-wiring section RCL_D may include two or more conductive layers (for example, metal layers) that are vertically overlapped with an insulating layer between them. For example, the multi-wiring section (RCL_D) may be a double-wiring section that includes two conductive layers that are vertically overlapped with each other with an insulating layer interposed therebetween. For another example, the multi-wiring section RCL_D may be a triple-wiring section that includes three conductive layers that are vertically overlapped with each other with an insulating layer between them. Hereinafter, the embodiments of the present disclosure will be described with an example in which the conductive layers are formed of metal layers, by the present disclosure is not limited thereto.

Accordingly, the resistance of at least one of the plurality of row connection lines RCL may be reduced. As a result, the signal transmission characteristics through at least one of the plurality of row connection lines RCL may be improved, and the performance of display driving and touch driving may be significantly improved. Here, for example, the signal transmission characteristics may include RC (Resistance-capacitance) delay characteristics and signal distortion characteristics.

Referring to FIG. 17, at least one of the plurality of row connection lines RCL may further include a single wiring section RCL_S in addition to the multi-wiring section RCL_D.

Each of the plurality of column lines CL may be a single wiring, but the present disclosure is not limited thereto.

In addition, as described above, in the display panel 110 according to the embodiments of the present disclosure, the plurality of drivers DRV may be disposed in the display area DA, and may be disposed between the substrate 210 and the plurality of light emitting devices ED.

As described above, the display panel 110 according to the embodiments of the present disclosure may further include a side protection layer 1513 which is an insulating layer disposed on a side of the plurality of drivers DRV, an upper protection layer 1514 which is an insulating layer disposed on the side protection layer 1513, a plurality of insulating layers 1515 disposed on the upper protection layer 1514, a bank BNK disposed on the plurality of insulating layers 1515, and optical layers 1517a and 1517b disposed on a side of the bank BNK.

The plurality of light emitting devices ED may be positioned on the bank BNK.

The optical layer 1517a and 1517b may be disposed on a side of the plurality of light emitting devices ED. For example, the optical layer 1517a and 1517b may include a first optical layer 1517a disposed on a side of the plurality of light emitting devices ED and a second optical layer 1517b surrounding the first optical layer 1517a.

The plurality of insulating layers 1515 may include a first insulating layer 1515a on the upper protection layer 1514, a second insulating layer 1515b on the first insulating layer 1515a, and a third insulating layer 1515c on the second insulating layer 1515b.

Referring to FIG. 18, the display panel 110 may further include a plurality of metal layers ML1 to ML5 disposed between the side protection layer 1513 and the optical layers 1517a and 1517b. For example, the plurality of metal layers ML1 to ML5 may be metal layers on which the line connection pattern LCP and the row connection electrode RCE of FIG. 10 are disposed.

Referring to FIG. 18 and FIG. 10, for example, the plurality of metal layers ML1 to ML5 may include a first metal layer ML1 between the side protection layer 1513 and the upper protection layer 1514, a second metal layer ML2 between the upper protection layer 1514 and the first insulating layer 1515a, a third metal layer ML3 between the first insulating layer 1515a and the second insulating layer 1515b, a fourth metal layer ML4 between the second insulating layer 1515b and the third insulating layer 1515c, and a fifth metal layer ML5 between the third insulating layer 1515c and the optical layer 1517a and 1517b.

Referring to FIG. 18 and FIG. 10, the display panel 110 may further include a sixth metal layer ML6 on which row lines RL are arranged, in addition to the first to fifth metal layers ML1 to ML5.

Referring to FIG. 18, the multi-wiring section RCL_D of the row connection line RCL may include two or more metal layers among the plurality of metal layers ML1 to ML5.

Referring to FIG. 17, each of the plurality of row connection lines RCL may include a multi-wiring section RCL_D, but each of the plurality of column lines CL may be a single wiring.

Referring to FIG. 17, the multi-wiring section RCL_D of the row connection line RCL may include a lower wiring part LL disposed in a lower metal layer among the plurality of metal layers, an upper wiring part UL disposed in an upper metal layer among the plurality of metal layers and vertically overlapping with the lower wiring part LL, a first connection wiring part CWP1 disposed in an intermediate metal layer between the lower metal layer and the upper metal layer among the plurality of metal layers and electrically connecting one end of the lower wiring part LL to one end of the upper wiring part UL, and a second connection wiring part CWP2 disposed in the intermediate metal layer and electrically connecting the other end of the lower wiring part LL to the other end of the upper wiring part UL.

Referring to FIG. 17, at least one of the plurality of column lines CL may pass between two or more metal layers forming the multi-wiring section RCL_D of the row connection line RCL. More specifically, at least one of the plurality of column lines CL may pass between the upper wiring part UL and the lower wiring part LL included in the multi-wiring section RCL_D of the row connection line RCL.

The column line CL may vertically overlap with the upper wiring part UL and the lower wiring part LL included in the multi-wiring section RCL_D of the row connection line RCL.

Referring to FIG. 18, the lower metal layer, the intermediate metal layer, and the upper metal layer constituting the row connection line RCL may be included in the plurality of metal layers ML1 to ML5. For example, the lower metal layer may be the first metal layer ML1, the upper metal layer may be the fifth metal layer ML5, and the intermediate metal layer may include the second to fourth metal layers ML2 to ML4. As another example, the lower metal layer may be a first metal layer ML1, the upper metal layer may be a fourth metal layer ML4, and the intermediate metal layer may include second and third metal layers ML2 and ML3. As another example, the lower metal layer may be a first metal layer ML1, the upper metal layer may be a third metal layer ML3, and the intermediate metal layer may be a second metal layer ML2. As another example, the lower metal layer may be a second metal layer ML2, the upper metal layer may be a fifth metal layer ML5, and the intermediate metal layer may include third and fourth metal layers ML3 and ML4. As another example, the lower metal layer may be a third metal layer ML3, the upper metal layer may be a fifth metal layer ML5, and the intermediate metal layer may include a fourth metal layer ML4.

The lower metal layer, the intermediate metal layer, and the upper metal layer constituting the column line CL may be included in a plurality of metal layers ML1 to ML5. For example, the lower metal layer may be a first metal layer ML1, the upper metal layer may be a fifth metal layer ML5, and the intermediate metal layer may include second to fourth metal layers ML2 to ML4. For example, the intermediate metal layers ML2, ML3 and ML4 may include at least one of the second metal layer ML2, the third metal layer ML3, and the fourth metal layer ML.

For example, one row connection line RCL may include a first multi-wiring section RCL_D1. One row connection line RCL may further include a second multi-wiring section RCL_D2. One row connection line RCL may further include a first single wiring section RCL_S1 that electrically connects a first multi-wiring section RCL_D1 and a driver DRV, and a second single wiring section RCL_S2 that electrically connects the first multi-wiring section RCL_D1 and the second multi-wiring section RCL_D2. The second multi-wiring section RCL_D2 may be electrically connected to the corresponding row line RL.

The first multi-wiring section RCL_D1 may include a first upper wiring part UL_1, a first lower wiring part LL_1 that vertically overlaps with the first upper wiring part UL_1, a first-1 connection wiring part CWP1_1 that electrically connects one end of the first upper wiring part UL_1 to one end of the first lower wiring part LL_1, and a first-2 connection wiring part CWP2_1 that electrically connects the other end of the first upper wiring part UL_1 to the other end of the first lower wiring part LL_1.

The first lower wiring part LL_1 and the first upper wiring part UL_1 may be disposed in different metal layers, and may vertically overlap with each other. At least one insulating layer may be disposed between the first lower wiring part LL_1 and the first upper wiring part UL_1. For example, referring to FIG. 10 and FIG. 18, the first lower wiring part LL_1 may be disposed within the first metal layer ML1, the first upper wiring part UL_1 may be disposed within the fifth metal layer ML5, and an upper protection layer 1514 and first to third insulating layers 1515a, 1515b and 1515c may be disposed between the first lower wiring part LL_1 and the first upper wiring part UL_1.

The first-1 connection wiring part CWP1_1 may be connected to one end of the first upper wiring part UL_1 and one end of the first lower wiring part LL_1 through a contact hole CTH, respectively. The first-2 connection wiring part CWP2_1 may be connected to the other end of the first upper wiring part UL_1 and the other end of the first lower wiring part LL_1 through a contact hole CTH.

The first-1 connection wiring part CWP1_1 may be configured with at least one metal layer among a plurality of metal layers ML2 to ML4. For example, the first-1 connection wiring part CWP1_1 may be configured with a wiring part formed of a second metal layer ML2, a wiring part formed of a third metal layer ML3, and a wiring part formed of a fourth metal layer ML4 that are connected through a contact hole CTH.

The first-2 connection wiring part CWP2_1 may be configured with at least one metal layer among a plurality of metal layers ML2 to ML4. For example, the first-2 connection wiring part CWP2_1 may be configured by connecting a wiring part composed of a second metal layer ML2, a wiring part composed of a third metal layer ML3, and a wiring part composed of a fourth metal layer ML4 through a contact hole CTH.

The second multi-wiring section RCL_D2 may include a second upper wiring part UL _2, a second lower wiring part LL_2 vertically overlapping with the second upper wiring part UL_2), a second-1 connection wiring part CWP1 2 electrically connecting one end of the second upper wiring part UL_2 to one end of the second lower wiring part LL_2, and a second-2 connection wiring part CWP2_2 electrically connecting the other end of the second upper wiring part UL_2 to the other end of the second lower wiring part LL_2.

The second lower wiring part LL_2 and the second upper wiring part UL_2 may be disposed in different metal layers, and may be vertically overlapped with each other. At least one insulating layer may be disposed between the second lower wiring part LL_2 and the second upper wiring part UL_2. For example, referring to FIG. 10 and FIG. 18, the second lower wiring part LL_2 may be disposed in the third metal layer ML3, the second upper wiring part UL_2 may be disposed in the fifth metal layer ML5, and a second insulating layer 1515b and a third insulating layer 1515c may be disposed between the second lower wiring part LL_2 and the second upper wiring part UL_2.

The second-1 connection wiring part CWP1_2 may be connected to one end of the second upper wiring part UL_2 and one end of the second lower wiring part LL_2 through a contact hole CTH, respectively. The second-2 connection wiring part CWP2_2 may be connected to the other end of the second upper wiring part UL_2 and the other end of the second lower wiring part LL_2 through a contact hole CTH, respectively.

The second-1 connection wiring part CWP1_2 may include at least one metal layer among the plurality of metal layers ML2 to ML4. For example, the second-1 connection wiring part CWP1 2 may include a wiring part composed of a fourth metal layer ML4.

The second-2 connection wiring part CWP2_2 may include at least one metal layer among the plurality of metal layers ML2 to ML4. For example, the second-2 connection wiring part CWP2_2 may include a wiring part composed of a fourth metal layer ML4.

The first single wiring section RCL_S1 may electrically connect the first multi-wiring section RCL_D1 and the driver DRV. For example, the first single wiring section RCL_S1 may be disposed in the first metal layer ML1 or the second metal layer ML2.

The second single wiring section RCL_S2 may electrically connect the first multi-wiring section RCL_D1)and the second multi-wiring section RCL_D2. For example, the second single wiring section RCL_S2 may include at least one of the first to fourth metal layers ML1 to ML4. For example, the second single wiring section RCL_S2 may include a single wiring part arranged in the first metal layer ML1 and a single wiring part arranged in the second metal layer ML2. In this disclosure, the phrase "the wiring, line, or electrode is disposed or arranged in the metal layer" may have the same meaning as "the wiring, line, or electrode is composed of or includes the metal layer."

Each of the plurality of column lines CL may include a plurality of single wiring parts each composed of a plurality of conductive layers (for example, metal layers). Two adjacent single wiring parts among the plurality of single wiring parts may be electrically connected through a contact hole CTH.

Each of the plurality of column lines CL may include a lower column line part CL1 disposed in a lower metal layer among the plurality of metal layers ML1 to ML5, an upper column line part CL5 disposed in an upper metal layer among the plurality of metal layers ML1 to ML5, and an intermediate column line part CL2 to CL4 disposed in an intermediate metal layer among the plurality of metal layers ML1 to ML5 and electrically connecting the lower column line part CL1 and the upper column line part CL5 in a series.

Referring to FIG. 18, the intermediate column line part CL2 to CL4 of the column line CL may pass between the upper wiring part UL and the lower wiring part LL included in the multi-wiring section RCL_D of the row connection line RCL. For example, one intermediate column line part CL4 among the intermediate column line parts CL2 to CL4 of the column line CL may pass between the upper wiring part UL and the lower wiring part LL included in the multi-wiring section RCL_D of the row connection line RCL, and may include one of the second metal layer ML2, the third metal layer ML3, and the fourth metal layer ML4.

The intermediate column line parts CL2 to CL4 of the column line CL may vertically overlap with the upper wiring part UL and the lower wiring part LL included in the multi-wiring section RCL_D of the row connection line RCL. It is to be noted that although FIGs. 17 and 18 show several layer structures and arrangements of the column lines CL, the row lines RL and the row connection lines RCL, but such layer structures and arrangements are provided by way of example only, and the present disclosure is not limited thereto, and various other layer structures and arrangements of the column lines CL, the row lines RL and the row connection lines RCL are also possible.

As described above, the display area DA of the display panel 110 may include a plurality of unit driving areas UDA corresponding to a plurality of drivers DRV, respectively. The plurality of unit driving areas UDA may include a first unit driving area UDA corresponding to a first driver DRV among the plurality of drivers DRV.

The first unit driving area UDA may include two or more row lines RL electrically connected to the first driver DRV among the plurality of row lines RL, and two or more column lines CL electrically connected to the first driver DRV among the plurality of column lines CL.

Each of the two or more column lines CL may be electrically connected to a first electrode of two or more light emitting devices arranged in the same column among the plurality of light emitting devices ED. Each of the two or more row lines RL may be electrically connected to a second electrode of two or more light emitting devices arranged in the same row among the plurality of light emitting devices ED.

The two or more row lines RL may include a first row line RL.

The plurality of row connection lines RCL may include a first row connection line RCL that electrically connects the first row line RL and the first driver DRV.

During a first period (e.g., PT1 of FIG. 15), the first row line RL may be supplied with a first low-potential voltage VSS1 from the first driver DRV through the first row connection line RCL. During a second period (e.g., PT2 of FIG. 15) different from the first period, the first row line RL may be supplied with a second low-potential voltage VSS2 different from the first low-potential voltage VSS1 from the first driver DRV through the first row connection line RCL.

During the first period, two or more light emitting devices overlapping with the first row line RL may emit light, and during the second period, two or more light emitting devices overlapping with the first row line RL may not emit light. Here, the second low-potential voltage VSS2 may be higher than the first low-potential voltage VSS1.

During the first period, the other row lines RL except the first row line RL among the two or more row lines RL may be supplied with the second low-potential voltage VSS2 from the first driver DRV. During the second period, one of the other row lines RL except the first row line RL among the two or more row lines RL may be supplied with the first low-potential voltage VSS1 from the first driver DRV.

During a third period (e.g., PT3 of FIG. 15) different from the first period and the second period, the first row line RL may be supplied with a touch driving signal TDS having a variable voltage level through the first row connection line RCL from the first driver DRV.

The low-level voltage of the touch driving signal TDS may be higher than the first low-potential voltage VSS1. Accordingly, it is possible to prevent or reduce the unwanted emission of the light emitting device ED during the touch driving period.

A display device 100 according to embodiments of the present disclosure may include a substrate 210, a plurality of light emitting devices ED disposed on the substrate 210 and positioned in a display area DA, a row line RL overlapping with the plurality of light emitting devices ED, and a row connection line RCL electrically connected to the row line RL and including a multi-wiring section RCL_D.

The display device 100 according to embodiments of the present disclosure may further include a driver DRV disposed on the substrate 210 and driving the row line RL.

During the first period, the row line RL may be supplied with a first low-potential voltage VSS1 through the row connection line RCL. During the second period different from the first period, the row line RL may be supplied with a second low-potential voltage VSS2 different from the first low-potential voltage VSS1 through the row connection line RCL. During the third period, which is different from the first and second periods, the row line RL may be supplied with a touch driving signal TDS having a variable voltage level through the row connection line RCL.

The display device 100 according to the embodiments of the present disclosure described above may be included in various devices or electronic devices. For example, various electronic devices may include a wearable device such as a smart watch, a mobile device, a laptop, and a monitor or a television (TV).

A display device according to an aspect of the present disclosure comprises: a substrate; a plurality of light emitting devices disposed on the substrate and positioned in a display area; a plurality of column lines electrically connected to a first electrode of each of the plurality of light emitting devices; a plurality of row lines electrically connected to a second electrode of each of the plurality of light emitting devices; a plurality of drivers configured to drive the plurality of column lines and the plurality of row lines; and a plurality of row connection lines electrically connecting the plurality of row lines and the plurality of drivers, wherein at least one of the plurality of row connection lines includes a multi-wiring section including two or more conductive layers vertically overlapping with each other with an insulating layer interposed therebetween.

In one or more embodiments, the plurality of drivers and the plurality of row connection lines are disposed in the display area.

In one or more embodiments, the plurality of drivers are disposed between the substrate and the plurality of light emitting devices.

In one or more embodiments, each of the plurality of column lines is a single wiring.

In one or more embodiments, at least one of the plurality of column lines passes between the two or more conductive layers forming the multi-wiring section.

In one or more embodiments, the display device further comprises: a side protection layers disposed on a side of the plurality of drivers; an upper protection layers disposed on the side protection layers; a plurality of insulating layers disposed on the upper protection layers; a bank disposed on the plurality of insulating layers; and an optical layer disposed on a side of the bank, wherein the plurality of light emitting devices are positioned on the bank, wherein the optical layer is disposed on a side of the plurality of light emitting devices.

In one or more embodiments, the display device further comprises a plurality of conductive layers disposed between the side protection layer and the optical layer, wherein the two or more conductive layers forming the multi-wiring section are included in the plurality of conductive layers.

In one or more embodiments, the multi-wiring section includes: a lower wiring part disposed in a lower conductive layer among the plurality of conductive layers; an upper wiring part disposed in an upper conductive layer among the plurality of conductive layers and vertically overlapping with the lower wiring part; a first connection wiring part disposed in an intermediate conductive layer located between the lower conductive layer and the upper conductive layer among the plurality of conductive layers and electrically connecting one end of the lower wiring part to one end of the upper wiring part; and a second connection wiring part disposed in the intermediate conductive layer and electrically connecting the other end of the lower wiring part to the other end of the upper wiring part.

In one or more embodiments, each of the plurality of column lines includes: a lower column line part disposed within the lower conductive layer; an upper column line part disposed within the upper conductive layer; and an intermediate column line part disposed within the intermediate conductive layer, and electrically connecting the lower column line part and the upper column line part in a series.

In one or more embodiments, the intermediate column line part passes between the upper wiring part and the lower wiring part.

In one or more embodiments, the intermediate column line part vertically overlaps with the upper wiring part and the lower wiring part.

In one or more embodiments, the display area includes a plurality of unit driving areas respectively corresponding to the plurality of drivers, and the plurality of unit driving areas include a first unit driving area corresponding to a first driver among the plurality of drivers, wherein the first unit driving area includes two or more row lines electrically connected to the first driver among the plurality of row lines, and two or more column lines electrically connected to the first driver among the plurality of column lines, wherein each of the two or more column lines is electrically connected to a first electrode of two or more light emitting devices arranged in the same column among the plurality of light emitting devices, and wherein each of the two or more row lines is electrically connected to a second electrode of two or more light emitting devices arranged in the same row among the plurality of light emitting devices.

In one or more embodiments, the plurality of row connection lines include a first row connection line that electrically connects a first row line among the two or more row lines and the first driver, wherein, during a first period, the first row line is supplied with a first low-potential voltage from the first driver through the first row connection line, and wherein, during a second period different from the first period, the first row line is supplied with a second low-potential voltage different from the first low-potential voltage from the first driver through the first row connection line.

In one or more embodiments, two or more light emitting devices overlapping with the first row line emit light during the first period, wherein the two or more light emitting devices overlapping with the first row line do not emit light during the second period, and wherein the second low-potential voltage is higher than the first low-potential voltage.

In one or more embodiments, during a third period different from the first period and the second period, the first row line is supplied with a touch driving signal having a variable voltage level from the first driver through the first row connection line.

In one or more embodiments, a low level voltage of the touch driving signal is higher than the first low-potential voltage.

In one or more embodiments, a frequency of the touch driving signal is variable according to time.

In one or more embodiments, the display device further comprises: a touch ground arranged below the first row line and supplied with a load-free driving signal whose signal characteristics correspond to the touch driving signal during the third period.

A display device according another aspect of the present disclosure comprises: a substrate; a plurality of light emitting devices disposed on the substrate; a first line overlapping with the plurality of light emitting devices; and a first connection line electrically connected to the first line, and including a multi-wiring section including two or more conductive layers vertically overlapping with each othe with an insulating layer interposed therebetween.

In one or more embodiments, the display device further comprises a driver disposed on the substrate and driving the first line.

In one or more embodiments, during a first period, the first line is supplied with a first low-potential voltage through the first connection line, wherein, during a second period different from the first period, the first line is supplied with a second low-potential voltage different from the first low-potential voltage through the first connection line.

In one or more embodiments, during a third period different from the first period and the second period, the first line is supplied with a touch driving signal having a variable voltage level through the first connection line.

A display device according to another aspect of the present disclosure comprises: a substrate; a driver disposed on the substrate; a plurality of light emitting devices disposed over the driver; and a first line overlapping with the plurality of light emitting devices and electrically connected with the plurality of light emitting devices, wherein during a touch period of the display device, the first line is supplied with a touch driving signal from the driver.

## Claims

1. A display device (100) comprising:
a substrate (210);
a plurality of light emitting devices (ED) disposed on the substrate (210) and positioned in a display area (DA);
a plurality of column lines (CL) electrically connected to a first electrode (Ecl) of each of the plurality of light emitting devices (ED);
a plurality of row lines (RL) electrically connected to a second electrode (Erl) of each of the plurality of light emitting devices (ED);
a plurality of drivers (DRV) configured to drive the plurality of column lines (CL) and the plurality of row lines (RL); and
a plurality of row connection lines (RCL) electrically connecting the plurality of row lines (RL) and the plurality of drivers (DRV),
wherein at least one of the plurality of row connection lines (RCL) includes a multi-wiring section (RCL_D) including two or more conductive layers vertically overlapping with each other with an insulating layer interposed therebetween.

2. The display device (100) of claim 1, wherein the plurality of drivers (DRV) and the plurality of row connection lines (RCL) are disposed in the display area (DA).

3. The display device (100) of claim 1 or 2, wherein the plurality of drivers (DRV) are disposed between the substrate (210) and the plurality of light emitting devices (ED).

4. The display device (100) of any of claims 1 to 3, wherein each of the plurality of column lines (CL) is a single wiring.

5. The display device (100) of any of claims 1 to 4, wherein at least one of the plurality of column lines (CL) passes between the two or more conductive layers forming the multi-wiring section (RCL_D).

6. The display device (100) of any of claims 1 to 5, further comprising:
a side protection layer (1513) disposed on a side of the plurality of drivers (DRV);
an upper protection layer (1514) disposed on the side protection layer (1513);
a plurality of insulating layers (1515) disposed on the upper protection layer (1514);
a bank (BNK) disposed on the plurality of insulating layers (1515); and
an optical layer (1517a) disposed on a side of the bank (BNK),
wherein the plurality of light emitting devices (ED) are positioned on the bank (BNK),
wherein the optical layer (1517a) is disposed on a side of the plurality of light emitting devices (ED).

7. The display device (100) of claim 6, further comprising a plurality of conductive layers disposed between the side protection layer (1513) and the optical layer (1517a),
wherein the two or more conductive layers forming the multi-wiring section (RCL_D) are included in the plurality of conductive layers.

8. The display device (100) of claim 7, wherein the multi-wiring section (RCL_D) includes:
a lower wiring part (LL) disposed in a lower conductive layer among the plurality of conductive layers;
an upper wiring part (UL) disposed in an upper conductive layer among the plurality of conductive layers and vertically overlapping with the lower wiring part (LL);
a first connection wiring part (CWP1) disposed in an intermediate conductive layer located between the lower conductive layer and the upper conductive layer among the plurality of conductive layers and electrically connecting one end of the lower wiring part (LL) to one end of the upper wiring part (UL); and
a second connection wiring part (CWP2) disposed in the intermediate conductive layer and electrically connecting the other end of the lower wiring part (LL) to the other end of the upper wiring part (UL).

9. The display device (100) of claim 8, wherein each of the plurality of column lines (CL) includes:
a lower column line part (CL1) disposed within the lower conductive layer;
an upper column line part (CL5) disposed within the upper conductive layer; and
an intermediate column line part (CL2, ..., CL4) disposed within the intermediate conductive layer, and electrically connecting the lower column line part (CL1) and the upper column line part (CL5) in a series.

10. The display device (100) of claim 9, wherein the intermediate column line part (CL2, ..., CL4) passes between the upper wiring part (UL) and the lower wiring part (LL), and/or
wherein the intermediate column line part (CL2, ..., CL4) vertically overlaps with the upper wiring part (UL) and the lower wiring part (LL).

11. The display device (100) of any of claims 1 to 10, wherein the display area (DA) includes a plurality of unit driving areas (UDA) respectively corresponding to the plurality of drivers (DRV), and the plurality of unit driving areas (UDA) include a first unit driving area (UDA) corresponding to a first driver (DRV) among the plurality of drivers (DRV),
wherein the first unit driving area (UDA) includes two or more row lines (RL) electrically connected to the first driver (DRV) among the plurality of row lines (RL), and two or more column lines (CL) electrically connected to the first driver (DRV) among the plurality of column lines (CL),
wherein each of the two or more column lines (CL) is electrically connected to a first electrode (Ecl) of two or more light emitting devices (ED) arranged in the same column among the plurality of light emitting devices (ED), and
wherein each of the two or more row lines (RL) is electrically connected to a second electrode (Erl) of two or more light emitting devices (ED) arranged in the same row among the plurality of light emitting devices (ED).

12. The display device (100) of claim 11, wherein the plurality of row connection lines (RCL) include a first row connection line (RCL) that electrically connects a first row line (RL) among the two or more row lines (RL) and the first driver (DRV),
wherein, during a first period (PT1), the first row line (EL) is supplied with a first low-potential voltage (VSS1) from the first driver (DRV) through the first row connection line (RCL), and
wherein, during a second period (PT2) different from the first period (PT1), the first row line (RL) is supplied with a second low-potential voltage (VSS2) different from the first low-potential voltage (VSS1) from the first driver (DRV) through the first row connection line (RCL).

13. The display device (100) of claim 12, wherein two or more light emitting devices (ED) overlapping with the first row line (RL) emit light during the first period (PT1),
wherein the two or more light emitting devices (ED) overlapping with the first row line (RL) do not emit light during the second period (PT2), and
wherein the second low-potential voltage (VSS2) is higher than the first low-potential voltage (VSS1).

14. The display device (100) of claim 12 or 13, wherein, during a third period (PT3) different from the first period (PT1) and the second period (PT2), the first row line (RL) is supplied with a touch driving signal (TDS) having a variable voltage level from the first driver (DRV) through the first row connection line (RCL),
wherein, preferably:
a low level voltage of the touch driving signal (TDS) is higher than the first low-potential voltage and/or a frequency of the touch driving signal (TDS) is variable according to time.

15. The display device (100) of claim 14, further comprising:
a touch ground (1710) arranged below the first row line (RL) and supplied with a load-free driving signal (LFDS) whose signal characteristics correspond to the touch driving signal (TDS) during the third period (PT3).
